# EUROPÄISCHE PATENTSCHRIFT

(11) **EP 1 897 152 B1**
(45) Veröffentlichungstag und Bekanntmachung des Hinweises auf die Patenterteilung: **01.04.2020**
(21) Anmeldenummer: 06791288.1
(22) Anmeldetag: 07.06.2006
(51) Int. Cl.: H01L 33/00, C09K 11/77

(54) **WELLENLÄNGENKONVERTIERENDES KONVERTERMATERIAL, LICHTABSTRAHLENDES OPTISCHES BAUELEMENT UND VERFAHREN ZU DESSEN HERSTELLUNG**
WAVELENGTH-CONVERTING CONVERTER MATERIAL, LIGHT-EMITTING OPTICAL COMPONENT, AND METHOD FOR THE PRODUCTION THEREOF
MATERIAU CONVERTISSEUR DE LONGUEUR D'ONDE, COMPOSANT OPTIQUE ELECTROLUMINESCENT ET SON PROCEDE DE PRODUCTION

(30) Priorität: 23.06.2005 DE 102005029258; 23.12.2005 DE 102005061828
(43) Veröffentlichungstag der Anmeldung: 12.03.2008
(73) Patentinhaber: OSRAM Opto Semiconductors GmbH, 93055 Regensburg (DE)
(72) Erfinder: BRUNNER, Herbert, 93161 Sinzing (DE); HÖHN, Klaus, 81301 Forchheim (DE)
(74) Vertreter: Epping - Hermann - Fischer
(86) Internationale Anmeldenummer: PCT/DE2006/000980
(87) Internationale Veröffentlichungsnummer: WO 2007/006246

(56) Entgegenhaltungen:
- EP-A- 1 369 935
- WO-A-03/093393
- DE-A1- 10 316 769
- US-B1- 6 734 465

## Beschreibung

Diese Patentanmeldung beansprucht jeweils die Priorität der deutschen Patentanmeldungen 102005029258.5 und 102005061828.6.

Gegenstand der vorliegenden Erfindung ist ein wellenlängenkonvertierendes Konvertermaterial gemäß Anspruch 1 sowie ein lichtemittierendes optisches Bauelement mit einem derartigen Konvertermaterial und ein Verfahren zu dessen Herstellung.

In der US 2004/0094757 ist eine wellenlängenkonvertierende Reaktionsharzmasse offenbart, die mit Leuchtstoffpartikeln versetzt ist. Die Leuchtstoffpartikel weisen besonders große Durchmesser auf, wobei bevorzugt d₅₀-Werte, gemessen in Q₃, zwischen einschließlich 10 µm und einschließlich 20 µm vorgesehen sind. Unter einem d₅₀-Wert ist der Mediandurchmesser zu verstehen, der anhand einer Verteilungssumme der Partikel ermittelt wird. "Q₃" steht hierbei für Masseverteilungssumme oder Volumenverteilungssumme. Um bei der Verwendung derart großer Leuchtstoffpartikel eine Sedimentierung von diesen in der Reaktionsharzmasse zu verhindern, ist der Reaktionsharzmasse ein Thixotropiermittel zugegeben.

Bei herkömmlichen wellenlängenkonvertierenden Reaktionsharzmassen ist bekannt, dass ein erhöhter Feinkornanteil der Leuchtstoffpartikel mit einem Durchmesser von kleiner als 1 µm zu Helligkeitsabnahmen und Verarbeitungsproblemen bei der Vorbereitung und der Herstellung des Konverterelements führt.

Ein weiterer bekannter Nachteil bei bekannten wellenlängenkonvertierenden Reaktionsharzmassen ist, dass der Leuchtstoffanteil in der Reaktionsharzmasse aus Verarbeitungsgründen nicht beliebig erhöht werden kann. Bei zu hohen Leuchtstoffkonzentrationen können Oberflächenwechselwirkungen zwischen den Leuchtstoffpartikeln zu Eintrübungen an der wellenlängenkonvertierenden Masse oder zu optischen Löschungen und damit zu Helligkeitsverlusten führen.

Bei herkömmlichen Leuchtstoffen, die in wellenlängenkonvertierenden Reaktionsharzmassen eingesetzt werden, führen geometrisch ungünstige Formen und Geometrien der Leuchtstoffpartikel, beispielsweise splittrige, kantige und eckige Leuchtstoffpartikel zu Verlusten beim Einkoppeln von Licht in die Leuchtstoffpartikel sowie beim Auskoppeln von Licht aus den Leuchtstoffpartikeln. Dadurch wird die Quantenausbeute von Leuchtdiodenbauelementen, in denen die wellenlängenkonvertierende Reaktionsharzmasse eingesetzt wird, herabgesetzt.

Um bei derartigen Leuchtdiodenbauelementen eine wirtschaftliche Lichtausbeute bei hoher Qualität zu erreichen, dürfen die Leuchtstoffe in den Reaktionsharzen weder während der Lagerung noch während der Verarbeitung bei erhöhten Temperaturen sedimentieren. Unter einer hohen Qualität ist bei Leuchtdiodenbauelementen beispielsweise ein homogenes Leuchtbild mit möglichst engen Farbortverteilungen, eine hohe und stabile Helligkeit sowie hohe Farbechtheit zu verstehen. Um eine Sedimentation zu verhindern, werden feindisperse, optisch inaktive Sedimentationsverzögerer wie beispielsweise Aerosil verwendet. Diese tragen weiter zu einer Helligkeitsabnahme in Leuchtdiodenbauelementen mit wellenlängenkonvertierender Reaktionsharzmasse bei.

Schließlich kann es beim Umgang mit Leuchtstoffpartikeln zu Dosier- und Abriebproblemen in der Prozesstechnik kommen.

Es ist eine Aufgabe der vorliegenden Erfindung, ein, verglichen mit dem Stand der Technik, verbessertes wellenlängenkonvertierendes Konvertermaterial anzugeben, die insbesondere für eine Verwendung in einem Leuchtdiodenbauelement geeignet ist, beispielsweise zum Einkapseln eines Lumineszenzdiodenchips. Zudem soll ein lichtemittierendes optoelektronisches Bauelement mit einem derartigen wellenlängenkonvertierenden Konvertermaterial angegeben werden. Ein Verfahren zum Herstellen eines lichtemittierendes optoelektronisches Bauelements sowie nach einem derartigen Verfahren hergestellte Bauelemente sollen ebenfalls angegeben werden.

Diese Aufgabe wird mit einem wellenlängenkonvertierenden Konvertermaterial gemäß Anspruch 1 sowie durch den Gegenstand des weiteren unabhängigen Verfahrensanspruchs 33 gelöst. Vorteilhafte Ausführungsformen und bevorzugte Weiterbildungen sind Gegenstand der jeweiligen abhängigen Patentansprüche.

Bei dem eingangs genannten wellenlängenkonvertierenden Konvertermaterial liegt ein Teil des Leuchtstoffs in Form von Nanopartikeln vor. Der Leuchtstoff kann alternativ auch vollständig in Form von Nanopartikeln vorliegen. Das Konvertermaterial weist bevorzugt mindestens ein Polymer, besonders bevorzugt ist es eine Polymermasse, die mit dem mindestens einen Leuchtstoff versetzt ist. Zusätzlich oder alternativ weist das Konvertermaterial mit Vorteil ein anorganisches Material auf, das mit Vorteil als ein Matrixmaterial für den Leuchtstoff fungiert. Es handelt sich dabei bevorzugt um anorganisches Glas, um ein keramisches Material oder um ein TCO (transparent conductive oxide) wie Indiumzinnoxid (ITO) oder Zinkoxid (ZnO).

Die Nanopartikel weisen einen Mediandurchmesser d₅₀ von kleiner als oder gleich 100 nm auf, wobei der Mediandurchmesser anhand einer Volumen- oder Massenverteilungssumme (Q₃) gemessener Partikeldurchmesser ermittelt wird. Es wird dabei angenommen, dass die Partikel die Form einer Kugel mit einem konstanten Durchmesser aufweisen. Eine Messung der Partikeldurchmesser lässt sich bei Nanopartikeln beispielsweise grundsätzlich mittels dynamischer Lichtstreuung (DLS-Verfahren) durchführen. Alternativ wird der Mediandurchmesser d₅₀ anhand einer Anzahl-Verteilungssumme Q₀ gemessener Partikelgrößen ermittelt. Zweckmäßigerweise können die Partikelgrößen hierbei unmittelbar gemessen werden, was beispielsweise mittels Aufnahmen eines Rasterelektronenmikroskopes und Anlegen des entsprechenden Maßstabes erfolgen kann. Geeignete Abbildungstechniken bei der Verwendung eines Rasterelektronenmikroskopes sind beispielsweise die FSEI-Technik (Forward Scattered Electron Imaging) oder die STEM-in-SEM-Technik (Scanning Transmission Electron Microscopy). Derartige Techniken sind beispielsweise in Proceedings of ISTFA 2004, "Microscopy at nanoscale", W.E. Vanderlinde et al. beschrieben, dessen Offenbarungsgehalt hiermit durch Rückbezug aufgenommen wird.

Weitere Messmethoden, die grundsätzlich zur Charakterisierung von Nanopartikeln geeignet sind, lassen sich der unten angegebenen Tabelle 1 entnehmen. Mit einigen dieser Messmethoden lassen sich im Einzellfall eventuell auch Verteilung, Form und Morphologie des Leuchtstoffes in Form von Nanopartikeln ermitteln. Die Methoden sind teilweise beschrieben in "Handbook of Microscopy Application in Material Science Solid-State Physics and Chemistry, 1997, Weinheim, New York: VCH." Die Begrifflichkeiten und Terminologien zur Partikelgrößencharakterisierung sind in der ISO 9276-1 "Representation of results of particle size analysis" näher dargestellt und erläutert.

**Tabelle 1)**

| **Methode** | **Abkürzung** | **Auflösungsbereich** |
|---|---|---|
| Small Angle Neutron Scattering | SANS | 0,001 - 10 µm |
| Small Angle X-Ray Scattering | SAXS | 0,001 - 31 µm |
| Differential Mobility Analysis (electrostatic classification) | DMA | 0,005 - 1 µm |
| Scanning Electron Microscopy | SEM | 0,02 - 10 µm |
| Transmission Electron Microscopy | TEM | 0,01 - 0,5 µm |
| Gas Adsorption Surface Area Analysis (Brunauer-Emmet-Teller) | BET | keine Einschränkung, spez. Oberfläche in g/m² |

Der in Form von Nanopartikeln vorliegende Leuchtstoff weist besonders einen Mediandurchmesser d₅₀ von kleiner als oder gleich 50 nm oder kleiner als oder gleich 30 nm und größer als oder gleich 1 nm auf.

Die Primärpartikel des in Form von Nanopartikeln vorliegenden Leuchtstoffs weisen jeweils eine Größe von kleiner als oder gleich 100 nm, bevorzugt von kleiner als oder gleich 50 nm, besonders bevorzugt von kleiner als oder gleich 30 nm auf.

Verglichen mit herkömmlichen Leuchtstoffpartikeln, die in lichtemittierenden optischen Bauelementen verwendet werden, kann mit Leuchtstoffpartikeln in Form von Nanopartikeln ein verbessertes homogenes Leuchtbild realisiert werden.

Gemäß einer besonders vorteilhaften Ausführungsform sind die Nanopartikel in der Polymermasse zumindest teilweise zu Agglomeraten verbunden. Die Nanopartikel sind insbesondere gezielt zu Agglomeraten verbunden. Bevorzugt weisen die Agglomerate einen d₅₀-Wert gemessen in Q₃ oder Q₀ auf, der größer als oder gleich 1 nm und kleiner als oder gleich 100 nm ist. Bei derart kleinen Agglomeraten sind demnach sowohl die Primärpartikel als auch die aus den Primärpartikeln zusammengesetzten Agglomerate Nanopartikel.

Üblicherweise wird im Zusammenhang mit Leuchtstoffpartikeln versucht, die Bildung von Agglomeraten so weit wie möglich zu vermeiden. Vor allem bei besonders großen Leuchtstoffpartikeln mit einer Größe von beispielsweise mehr als 5 µm führt die Bildung von Agglomeraten zu einer Verschlechterung der Homogenität des konvertierten Lichtes. Es ist auch möglich, dass eine Agglomeratbildung von Leuchtstoff-Primärpartikeln zu einer verringerten Konversionseffizienz führt, beispielsweise auf Grund von Reabsorption konvertierter Strahlung.

Im Zusammenhang mit der vorliegenden Erfindung wurde überraschend festgestellt, dass eine gezielte Ausbildung von Agglomeraten mit kleinen Durchmessern, die sich aus Nanopartikeln zusammensetzen oder Nanopartikel aufweisen, für die Konversionseffizienz und/oder für die Abstrahlcharakteristik von konvertierter Strahlung vorteilhaft sein kann. Bei Leuchtstoffen in Form von Nanopartikeln ist es möglich, durch eine gezielte Bildung von Agglomeraten Konversionselemente zu realisieren, die verglichen mit herkömmlichen Konversionselementen eine homogenere Abstrahlcharakteristik von konvertierter Strahlung aufweisen. Die Streupartikel sind insbesondere farblos und transparent.

Gemäß einer vorteilhaften Ausführungsform ist das wellenlängenkonvertierende Konvertermaterial frei von einem optisch inaktiven Sedimentationsverzögerer oder Thixotropiermittel. Durch die Verwendung eines Leuchtstoffs, der zumindest teilweise in Form von Nanopartikeln vorliegt, ist die Gefahr einer Sedimentationsbildung der Leuchtstoffpartikel signifikant verringert.

Gemäß einer weiteren vorteilhaften Ausführungsform weist das wellenlängenkonvertierende Konvertermaterial mindestens zwei verschiedene Leuchtstoffe auf. Bevorzugt eignen sich diese Leuchtstoffe, um durch eine Überlagerung der von ihnen emittierten Spektren weißes, d.h. im wesentlichen farbloses Licht zu erzeugen. Zudem kann mit derartigen Leuchtstoffen Licht mit einer hohen Farbechtheit, d.h. mit einer hohen Farbwiedergabe erzeugt werden. Der Colour Rendering Index CRI des mit derartigen Leuchtstoffen herzeugten Lichtes ist mit Vorteil größer als oder gleich 70, bevorzugt größer als oder gleich 80.

Mit Vorteil liegen die mindestens zwei Leuchtstoffe zumindest teilweise in Form von Nanopartikeln vor. Alternativ ist mit Vorteil vorgesehen, dass nur einer der Leuchtstoffe zumindest teilweise in Form von Nanopartikeln vorliegt. Hierbei können die in Form von Nanopartikeln vorliegenden Leuchtstoffe z.B. als ein optisch aktives Thixotropiermittel oder als Sedimentationsverzögerer für weitere in dem Konvertermaterial enthaltene Leuchtstoffpartikel, die deutlich größer sein können, dienen.

In einer bevorzugten Ausführungsform weist der Leuchtstoff zusätzlich Leuchtstoffpartikel mit einem d₅₀-Wert gemessen in Q₃ von größer als oder gleich 0,1 µm und kleiner als oder gleich 25 µm auf oder weist das Konvertermaterial einen weiteren Leuchtstoff mit derartigen Leuchtstoffpartikeln auf. Besonders bevorzugt haben diese zusätzlichen Leuchtstoffpartikel einen d₅₀-Wert von größer als oder gleich 1 µm, insbesondere von mindestens 5 µm. Zusätzlich oder alternativ ist es bevorzugt, wenn die zusätzlichen Leuchtstoffpartikel einen d₅₀-Wert von kleiner als oder gleich 20 µm aufweisen. Es versteht sich, dass der d₅₀-Wert im Zusammenhang der vorliegenden Erfindung bevorzugt in Q₃ gemessen ist, d.h. anhand einer Masseverteilungssumme oder Volumenverteilungssumme bestimmt ist. Alternativ ist der Mediandurchmesser d₅₀ anhand einer Anzahlverteilungssummme Q₀ bestimmt.

Mit einem zumindest teilweise in Form von Nanopartikeln vorliegenden Leuchtstoff können mit Vorteil reproduzierbare, möglichst fremdphasenfreie Leuchtstoffpartikel oder Leuchtstoffpigmentverteilungen mit reproduzierbaren Partikelformen bzw. Pigmentformen hergestellt werden.

Gemäß einer weiteren vorteilhaften Ausführungsform weist das Konvertermaterial mindestens einen anorganischen Leuchtstoff in Form von Nanopartikeln und mindestens einen organischen Leuchtstoff auf. Für die Kombination mit anorganischen Leuchtstoffen in Form von Nanopartikeln eignen sich insbesondere lösliche oder gelöste organische Leuchtstoffe.

Zweckmäßigerweise sind in dem Konvertermaterial optisch nicht anregbare Streupartikel mit einem d₅₀-Wert gemessen in Q₃ oder Q₀ von größer als oder gleich 100 nm und kleiner als oder gleich 10 µm enthalten. Dadurch kann die Homogenität des von dem Konvertermaterials emittierten Lichtes gezielt zusätzlich beeinflusst werden, was im Zusammenhang mit Leuchtstoffen in Form von Nanopartikeln von besonderer Bedeutung ist, da diese geringe Streueigenschaften aufweisen.

Der in Form von Nanopartikeln vorliegende Leuchtstoff enthält mit Vorteil gleichartige Partikel mit denselben Bestandteilen eines Wirtsgittermaterials oder mit demselben Wirtsgittermaterial, wobei die gleichartigen Partikel mindestens einen Aktivator mit unterschiedlichen Aktivatorkonzentrationen aufweisen. Bevorzugt beträgt die Aktivatorkonzentration eines erstens Teils der gleichartigen Partikel zwischen einschließlich 0,1 Atom% und einschließlich 3 Atom% und die Aktivatorkonzentration eines zweiten Teils der gleichartigen Partikel zwischen 3 Atom% und einschließlich 10 Atom%. Durch unterschiedliche Aktivatorkonzentrationen können Emissionseigenschaften des in Form von Nanopartikeln vorliegenden Leuchtstoffes beeinflusst werden.

Bevorzugt beträgt die Konzentration des Leuchtstoffs in dem wellenlängenkonvertierenden Konvertermaterial maximal 80 Gew-%, besonders bevorzugt maximal 60 Gew-%.

Gemäß einer alternativen Ausführungsform liegt der Anteil des Leuchtstoffs in dem Konvertermaterial zwischen einschließlich 60 Gew-% und einschließlich 80 Gew-%. Derart hohe Leuchtstoffkonzentrationen können beispielsweise von Vorteil sein, um Lumineszenzdiodenchips herzustellen, die mit einer wellenlängenkonvertierenden Schicht versehen sind.

Das wellenlängenkonvertierende Konvertermaterial weist zweckmäßigerweise mindestens eines der Materialien Epoxidgießharz, Epoxidharzpressmasse, Acrylat, Silikon und Thermoplast auf.

Bevorzugt weist das Konvertermaterial mindestens ein Hybridmaterial auf, das Silikon und mindestens eines der Materialien Epoxidharz und Acrylat aufweist. Durch die Mischung oder eine sonstige Kombination verschiedener Materialien innerhalb eines Hybridmaterials lässt sich beispielsweise gezielt ein Brechungsindex des Hybridmaterials einstellen, sodass die Brechungsindizes des Leuchtstoffes und des ihn umgebenden Matrixmaterials des Konvertermaterials aufeinander abgestimmt werden können. Mit Hybridmaterialien ist es möglich, die positiven Eigenschaften verschiedener Materialien miteinander zu kombinieren. Dadurch können beispielsweise nachteilige Eigenschaften eines Materials abgeschwächt oder eliminert werden.

Gemäß einer vorteilhaften Ausführungsform weist das Konvertermaterial mindestens einen Thermoplast aus der Gruppe bestehend aus Poly-n-methylmethacrylimid (PMMI), Polycarbonate (PC), Polyamide (PA), Polystyrol (PS), cykloolefinische Polymere (COP) und Copolymere (COC) auf.

Zusätzlich oder alternativ weist das Konvertermaterial mindestens ein additionsvernetzendes Silikon auf, das bevorzugt thermisch oder photonisch, d.h. unter Einfluß von elektromagnetischer Strahlung, härtend ist. Das photonisch härtende Material härtet bevorzugt unter Einfluss von elektromagnetischer Strahlung aus dem UV-Bereich.

Bevorzugt sind anorganische Leuchtstoffpartikel in dem Konvertermaterial enthalten. Der Leuchtstoff enthält mit besonderem Vorteil zumindest Leuchtstoffpartikel aus der Gruppe der mit seltenen Erden dotierten Granate, mit seltenen Erden dotierten Thiogallate, mit seltenen Erden dotierten Aluminate oder mit seltenen Erden dotierten Orthosilikate. Zusätzlich oder alternativ weist der Leuchtstoff bevorzugt Leuchtstoffpartikel aus oxidischen Wirtsgittern, wie Y₂O₃, Gd₂O₃, La₂O₃ Pr₂O₃, ZrO₂, TiO₂, ZnO, ZnGa₂O₄ auf. Diese Leuchtstoffpartikel weisen mit Vorteil als Aktivator mindestens ein Element aus der Gruppe bestehend aus den seltenen Erden, Mn, Ag und Cr auf.

Die Aktivatorkonzentration beträgt bei Leuchtstoffen mit einem Wirtsgitter und Aktivatoratomen mit Vorteil weniger als oder gleich 10 Atom%, bevorzugt weniger als oder gleich 5 Atom%. Dies gilt insbesondere auch dann mit Vorteil, wenn gleichartige Leuchtstoffpartikel mit unterschiedlichen Aktivatorkonzentrationen enthalten sind. Alternativ kann es jedoch insbesondere bei Leuchtstoffen in Form von Nanopartikeln von Vorteil sein, wenn die Konzentration von Aktivatoratomen größer als 10 Atom% ist, beispielsweise größer als oder gleich 15 Atom%.

Die Leuchtstoffpartikel weisen als Aktivator-Ionen generell bevorzugt Elemente der Lanthanide, Mangan, Chrom, Silber oder Uranyl auf.

Gemäß einer weiteren Ausführungsform ist mindestens ein Leuchtstoff mit einem Wirtsgitter enthalten, in dem mindestens zwei verschiedene Elemente gleichzeitig als Aktivator enthalten sind. Besonders bevorzugt liegt dieser Leuchtstoff zumindest teilweise in Form von Nanopartikeln vor. Das gleichzeitige Vorhandensein zweier unterschiedlicher Aktivatoren in demselben Wirtsgitter kann jedoch auch unabhängig von der Größe der Leuchtstoffpartikel von Vorteil sein, d.h. bei einem wellenlängenkonvertierenden Konvertermaterial mit einem derartigen Leuchtstoff muss nicht zwingend ein Teil des Leuchtstoffes oder der gesamte Leuchtstoff in Form von Nanopartikeln vorliegen.

In einer weiteren vorteilhaften Ausführungsform weist die Konvertermaterial mindestens ein Reaktionsharz mit mindestens einer lagerstabilen Härterformulierung als Epoxidgießharzformulierung auf. Die Härterformulierung weist bevorzugt einen oder mehrere der Stoffe Carbonsäureanhydride mit sauren Estern (Carbonsäureanhydridhalbester), Flexibilisatoren, organische Phosphorverbindungen, Initiatoren und Beschleuniger auf. Besonders bevorzugt weist die Härterformulierung mindestens eine Komplexverbindung des farblosen Zn²⁺-Ions als Beschleuniger auf, wobei diese Komplexverbindung mit Vorteil organische ionische Liganden aufweist. Mit besonderem Vorteil ist Zinkoktoat als Beschleuniger enthalten. Das Zinkoktoat oder die Komplexverbindung des farblosen Zn²⁺-Ions weist bevorzugt einen Zn²⁺-Gehalt von größer als oder gleich 21 Gewichts-% auf. Zweckmäßigerweise beträgt der Zn²⁺-Gehalt der Komplexverbindung des farblosen Zn²⁺-Ions mehr als 10 Gewichts-%, mit Vorteil mehr als 20 Gewichts-%.

Gemäß einer nicht erfindungsgemäßen Ausführungsform liegt das Konvertermaterial teilweise oder vollständig als eine Schicht vor, die nicht in Form einer Folie ist. Unter einer Schicht ist in diesem Zusammenhang bevorzugt ein Körper zu verstehen, der eine flächenhafte Ausdehnung und senkrecht zur lokalen Ausdehnungsrichtung eine Dicke aufweist, die sehr viel geringer ist als seine gesamte Ausdehnung. Die flächenhafte Ausdehnung der Schicht verläuft besonders bevorzugt eben. Ebenfalls besonders bevorzugt weist die Schicht zu einem Großteil oder vollständig eine konstante Dicke auf. Randbereiche oder definierte Bereiche im inneren der Schicht können mit Vorteil auch eine geringere Dicke als die übrigen Bereiche der Schicht aufweisen. Durch eine solche Maßnahme kann in Verbindung mit einem lichtabstrahlenden Bauelement eine besonders homogene Abstrahlcharakteristik mit geringen Farbortschwankungen in Abhängigkeit vom Emissionswinkel realisiert werden.

Die Schicht weist mit besonderem Vorteil eine Dicke von kleiner als oder gleich 50 µm auf. Für einige Applikationen kann eine noch geringere Obergrenze für die Dicke der Schicht vorteilhaft sein. Entsprechend weist die Schicht gemäß einer weiteren vorteilhaften Ausführungsform eine Dicke von kleiner als oder gleich 5 µm auf.

Erfindungsgemäß liegt das Konvertermaterial als eine Folie vor. Bei der Herstellung lichtabstrahlender optischer Bauelemente ist es möglich, das Konvertermaterial unabhängig vom übrigen Bauelement als Folie herzustellen und auf eine Strahlungsquelle aufzubringen. Dies ist technisch einfach durchführbar und ermöglicht eine hohe Reproduzierbarkeit sowie ein genaues Einstellen des resultierenden Farbortes eines von dem Bauelement emittierten Lichtes.

Das lichtabstrahlende optische Bauelement weist eine Strahlungsquelle und ein wellenlängenkonvertierendes Konvertermaterial auf, mittels dem eine von der Strahlungsquelle emittierte elektromagnetische Strahlung teilweise oder vollständig in Strahlung mit veränderten Wellenlängen konvertiert wird. Das Bauelement ist besonders bevorzugt für Allgemeinbeleuchtung, das heißt insbesondere zur Beleuchtung von Räumen innerhalb von Gebäuden sowie im Freien geeignet. Durch die Verwendung von Leuchtstoffen in Form von Nanopartikeln ist ein sehr genaues Einstellen des Farbortes des vom optischen Bauelement emittierten Licht möglich, was für die Allgemeinbeleuchtung besonders vorteilhaft ist. Durch die Kombination geeigneter Leuchtstoffe lässt sich somit nicht nur ein wohl definierter Farbort, sondern auch eine sehr gute und wohl definierte Farbwiedergabe des lichtabstrahlenden Bauelementes gezielt einstellen.

Die Lichtquelle weist mit Vorteil eine organische Lumineszenzdiode, insbesondere eine organische Leuchtdiode (OLED) auf. Die organische Lumineszenzdiode ist mit dem Konvertermaterial versehen oder weist das Konvertermaterial auf, wobei das Konvertermaterial teilweise oder vollständig als eine Schicht vorliegt.

Zusätzlich oder alternativ weist die Lichtquelle einen Lumineszenzdiodenchip auf. Der Lumineszenzdiodenchip ist mit dem Konvertermaterial versehen, wobei das Konvertermaterial teilweise oder vollständig als eine Schicht vorliegt.

In einer weiteren Ausführungsform wird die Strahlungsquelle in dem Bauelement im Pulsbetrieb betrieben und/oder ist das Bauelement für optische Schaltprozesse vorgesehen. Leuchtstoffe in Form von Nanopartikeln haben kürzere Ansprech- und Abklingzeiten als Leuchtstoffe in Form von deutlich größeren Partikeln. Dadurch eignen sich derartige Leuchtstoffe grundsätzlich auch mit Vorteil für einen Pulsbetrieb oder/oder für Schaltprozesse mit kurzen Schaltzeiten.

Es wird ein Verfahren zum Herstellen eines lichtabstrahlenden optischen Bauelements angegeben. Bei dem Verfahren wird eine elektromagnetische Strahlungsquelle bereitgestellt und mit einem wellenlängenkonvertierenden Konvertermaterial versehen. Das Konvertermaterial weist mindestens einen wellenlängenkonvertierenden Leuchtstoff auf, der zumindest teilweise in Form von Nanopartikeln vorliegt. Bevorzugt weist das Konvertermaterial teilweise oder vollständig die Form einer Schicht mit einer Dicke von kleiner als oder gleich 50 µm auf.

Es ist möglich, das Konvertermaterial mittels eines Beschichtungsvorgangs im Rahmen eines nichterfindungsgemäßen Verfahrens in Schichtform auszubilden. Erfindungsgemäß wird ein schichtförmiges Konvertermaterial bereitgestellt und auf der Strahlungsquelle aufgebracht. Hierzu liegt das Konvertermaterial als eine flexible Folie vor.

In einer besonders vorteilhaften Ausführungsform des Verfahrens wird zumindest ein Teil der Nanopartikeln als mindestens eine Suspension in einem organischen Lösungsmittel bereitgestellt. Die Suspension wird in Ausgangskomponenten des Konvertermaterials eingearbeitet, wobei es sich bei den Ausgangskomponenten insbesondere um Ausgangskomponenten eines herzustellenden Matrixmateriales oder um ein Matrixmaterial selbst handeln kann. Nachfolgend wird das Lösungsmittel aus dem Konvertermaterial entfernt. Durch die Verwendung eines derartigen Verfahrens lassen sich die Nanopartikel kontrolliert in das Konvertermaterial einarbeiten.

Unerwünschte Sedimentationen können auf diese Weise weitgehend verhindert werden. Zudem kann eine gezielte Ausbildung von Agglomeraten mit den Nanopartikeln bewirkt werden.

In dem Lösungsmittel sind die Leuchtstoff-Nanopartikel mit Vorteil mit einer Konzentration von bis zu 90 Gewichts-% enthalten.

Das Lösungsmittel weist zweckmäßigerweise mindestens einen der Stoffe Alkohol, Glykolether, Tetrahydrofuran (THF), Dioxan und Ethylacetat (EtAc) auf.

Weiterhin ist zweckmäßigerweise vorgesehen, für das Einarbeiten der Suspension mindestens eine der Stoffarten Netzmittel, Haftungsvermittler und Glykolether zu verwenden.

In einer weiteren Ausführungsform des Verfahrens wird zumindest ein Teil des Konvertermaterials als mindestens eine Suspension von zumindest eines Teils des Leuchtstoffes mit einem Lösungsmittel bereitgestellt und die Suspension auf die Strahlungsquelle aufgebracht wird. Unter einer Suspension ist in diesem Zusammenhang ein Stoff gemeint, der neben dem festen Leuchtstoff mindestens einen weiteren, das Lösungsmittel enthaltenden Stoff aufweist, der in einer flüssigen Phase vorliegt, d.h. eine Suspension ist ein Stoff mit sowohl festen als auch flüssigen Phasen. Die Suspension kann mit Vorteil als ein Gel, als ein Sol oder eine kolloidale Lösung vorliegen. Zudem ist die Suspension mit Vorteil niederviskos oder hochviskos. Unter "niederviskos" ist eine Viskosität bis zu ca. 500 mPas zu verstehen, insbesondere bis zu 200 mPas. Unter "hochviskos" ist eine Viskosität ab ca. 500 mPas zu verstehen, insbesondere ab 1000, 10000 oder sogar 100000 mPas.

Das Lösungsmittel kann mit Vorteil Wasser oder ein organisches Lösungsmittel sein. Das organische Lösungsmittel weist zweckmäßigerweise mindestens einen der Stoffe Alkohol, Glykolether, Tetrahydrofuran (THF), Dioxan und Ethylacetat (EtAc) auf.

Die Suspension kann weitere Zusätze enthalten. Mit Vorteil ist ein Haftvermittler als Zusatz enthalten. Zusätzlich oder alternativ ist ein Entlüfter in der Suspension enthalten. Als weiteren zusätzlichen oder alternativen Zusatz weist die Suspension mit Vorteil mindestens ein Fließadditiv auf. Gemäß einer zweckmäßigen Ausführungsform kann zusätzlich oder alternativ auch ein Füllstoff wie z.B. Aerosil enthalten sein. Der Füllstoff ist bevorzugt fein- bis feinstdispers. Ein feindisperser Füllstoff weist Partikel mit einer spezifischen Oberfläche von größer als oder gleich 10 m²/g auf, ein feinstdisperser Füllstoff weist Partikel mit einer spezifischen Oberfläche von größer als oder gleich 100 m²/g auf, wobei die spezifische Oberfläche jeweils nach BET zu ermitteln ist.

Das Aufbringen eines als Suspension vorliegenden Lumineszenzkonversionsmaterials erfolgt mit Vorteil mittels eines Dispensers mit einem Dosierventil (Dispensen), mittels eines Druckverfahrens, und/oder mittels Spin-Coating. Bevorzugt erfolgt das Aufbringen mittels eines Tintenstrahldruckverahrens.

Mit dem Verfahren ist es möglich, einen Farbort des Bauelements mit hoher Genauigkeit sowie hoher Reproduzierbarkeit einzustellen. Es werden lichtabstrahlende optische Bauelemente angegeben, die nach dem Verfahren hergestellt sind und für die derselbe Farbort in dem CIE-Farbdiagramm des von den Bauelementen in einer Hauptabstrahlrichtung emittierten Lichtes vorgesehen ist. Dieser Farbort der lichtabstrahlenden optischen Elemente ist derart genau eingestellt, dass die Werte der X- und Y-Koordinate der resultierenden Farborte mit einer statistischen Sicherheit von mindestens 95 % innerhalb eines Intervalles mit einer Größe von kleiner als oder gleich 0,006 liegen. Bevorzugt liegen die Werte der X- und Y-Koordinate der resultierenden Farborte mit einer statistischen Sicherheit von mindestens 95 % innerhalb eines Intervalles mit einer Größe von kleiner als oder gleich 0,004, besonders bevorzugt von kleiner als oder gleich 0,002.

Das lichtabstrahlende optische Bauelement weist ein wellenlängenkonvertierendes Konvertermaterial auf, das ein oder mehrere der vorhergehend genannten Merkmale umfasst.

Weitere Vorteile, bevorzugte Ausführungsformen und Weiterbildungen des wellenlängenkonvertierenden Konvertermaterials und des lichtemittierenden optischen Bauelements ergeben sich aus den im Folgenden in Verbindung mit den Figuren erläuterten Ausführungsbeispielen. Es zeigen:
- Figur 1: eine schematische Schnittansicht eines ersten nichterfindungsgemäßen lichtabstrahlenden optischen Bauelements mit eines nichterfindungsgemäßen wellenlängenkonvertierenden Konvertermaterials;
- Figur 2: eine schematische Schnittansicht eines zweiten lichtabstrahlenden optischen Bauelements mit eines wellenlängenkonvertierenden Konvertermaterials;
- Figur 3: eine schematische Schnittansicht eines dritten nichterfindungsgemäßen lichtabstrahlenden optischen Bauelements mit eines nichterfindungsgemäßen wellenlängenkonvertierenden Konvertermaterials;
- Figur 4: eine schematische Schnittansicht eines vierten nichterfindungsgemäßen lichtabstrahlenden optischen Bauelements mit einem nichterfindungsgemäßen wellenlängenkonvertierenden Konvertermaterial;
- Figur 5: eine schematische Schnittansicht eines fünften lichtabstrahlenden optischen Bauelements mit einem wellenlängenkonvertierenden Konvertermaterial;
- Figur 6: eine schematische Schnittansicht eines sechsten lichtabstrahlenden optischen Bauelements mit einem wellenlängenkonvertierenden Konvertermaterial;
- Figur 7: eine schematische Darstellung eines Leuchtstoffes in Form von Nanopartikeln, die nicht agglomeriert sind;
- Figur 8: eine schematische Darstellung eines Leuchtstoffes in Form von Primärpartikeln, die zu Agglomeraten verbunden sind;
- Figuren 9 bis 11: schematische Darstellungen verschiedener Verfahrensstadien eines Ausführungsbeispiels des Verfahrens;
- Figur 12: eine schematische Schnittansicht eines siebten lichtabstrahlenden optischen Bauelements mit einem wellenlängenkonvertierenden Konvertermaterial;
- Figur 13: eine schematische Schnittansicht eines achten lichtabstrahlenden optischen Bauelements mit einem wellenlängenkonvertierenden Konvertermaterial;
- Figur 14: eine schematische Schnittansicht eines neunten lichtabstrahlenden optischen Bauelements mit einem wellenlängenkonvertierenden Konvertermaterial;
- Figur 15: eine schematische Schnittansicht eines zehnten lichtabstrahlenden optischen Bauelements mit einem wellenlängenkonvertierenden Konvertermaterial; und
- Figur 16: eine schematische Schnittansicht eines elften Licht abstrahlenden optischen Bauelements mit einem wellenlängenkonvertierenden Konvertermaterial.

In den verschiedenen Figuren sind gleiche bzw. gleichwirkende Teile immer mit denselben Bezugszeichen bezeichnet.

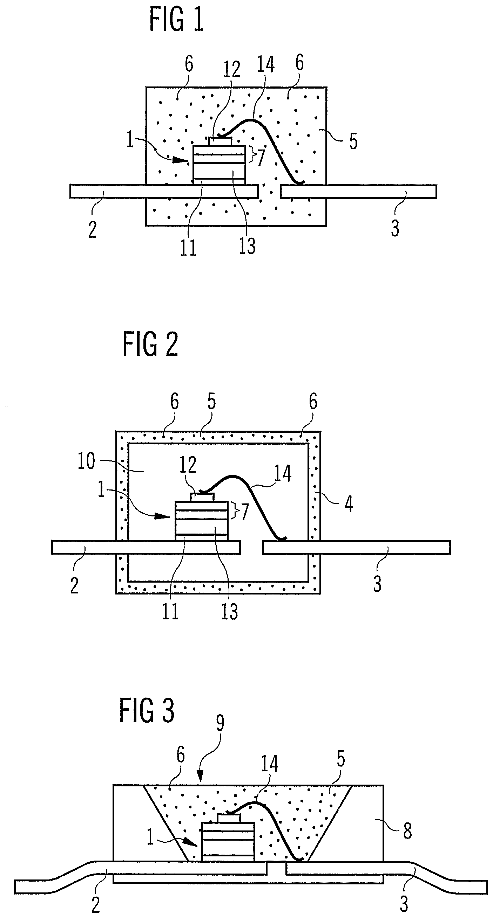

Das lichtemittierende Halbleiterbauelement von Figur 1 weist ein wellenlängenkonvertierendes Konvertermaterial auf. Dieses beinhaltet mindestens ein transparentes, d.h. strahlungsdurchlässiges, bevorzugt vergilbungsstabiles und insbesondere hydrolyse- und temperaturfestes Polymer.

Das Bauelement weist einen Halbleiterkörper 1, z.B. einen Lumineszenzdiodenchip auf. Dieser ist mittels eines elektrisch leitenden Verbindungsmittels 7 mit seinem Rückseitenkontakt 11 auf einem ersten elektrischen Anschluss 2 eines Leiterrahmens (Leadframe) befestigt.

Der Halbleiterkörper 1 weist eine aktive Schicht oder Schichtenfolge 7 mit einer Schicht oder einer Mehrzahl von Schichten auf der Basis von In_{xG}a_{y}Al_{1-x-y}N, wobei 0≤x≤1, 0≤y≤1 und x+y≤1. Die Schicht oder Schichtenfolge 7 weist zum Beispiel eine Multi-Quantenwell-Struktur auf. Der Lumineszenzdiodenchip enthält beispielsweise ein Substrat 13. Alternativ kann er auch frei von einem Substrat sein.

Als elektrisches Verbindungsmittel wird z. B. ein metallisches Lot, insbesondere Weichlot, oder ein Klebstoff verwendet. Der Vorderseitenkontakt 12 ist mittels eines Bonddrahtes 14 mit einem zweiten elektrischen Anschluss 3 des Leiterrahmens verbunden.

Die freien Oberflächen des Halbleiterkörpers 1 und Teilbereiche der elektrischen Anschlüsse 2 und 3 sind unmittelbar von dem Konvertermaterial 5 umschlossen.

Das Konvertermaterial ist z.B. eine gehärtete, wellenlängenkonvertierende Reaktionsharzmasse, d.h. es weist eine Reaktionsharzmasse als Polymer auf. Geeignete Materialien hierfür sind z.B. Epoxidharz und zusätzlich oder alternativ mindestens ein Acrylat.

Als Polymer des Konvertermaterials 5 kann auch ein Polymer-Hybridmaterial verwendet werden. Als Hybridmaterialien kommen z.B. Silikon-modifizierte Epoxidharze in Frage, die bei Einwirkung von ultraviolettem Licht weniger stark altern als herkömmliche Epoxidharze, im Übrigen jedoch im Wesentlichen die positiven physikalischen Eigenschaften herkömmlicher Epoxidharze aufweisen. Es ist auch möglich, mindestens ein Epoxidharz und mindestens ein Silikon miteinander zu mischen. Beispiele für derartige geeignete Hybridmaterialien sind beispielsweise in der US 2002/0192477 A1 oder in der US 2005/0129957 A1 angegeben, deren Offenbarungsgehalt insofern hiermit durch Rückbezug aufgenommen wird. Es ist auch möglich, Silikon mit Acrylat oder auch Silikon mit Acrylat und Epoxidharz zu kombinieren.

Das Konvertermaterial 5 weist mit Vorteil eine mehrkomponentige Harzformulierung auf, beispielsweise ein zweikomponentiges Epoxidharz. Diesem Harz kann neben Leuchtstoffpartikeln zusätzlich noch mindestens einer der Stoffe Glykolether und/oder Glykolmonoether mit ≤ 3 Gew%, Silanhaftvermittler mit ≤ 3 Gew% und Benetzungsmittel auf Silikonbasis mit ≤ 1 Gew% zugesetzt sein. Beispielsweise sind Diethylenglykolmonomethylether ≤ 2 Gew% und Tegopren 6875-45 ≤ 2 Gew% zugesetzt. Die Gew%-Angaben sind auf die A-Komponente des Polymers oder Epoxidharzes bezogen.

Reaktionsharze als Epoxidgießharzformulierung, die für das Konvertermaterial 5 verwendet werden, sind bevorzugt lagerstabil und weisen hierzu z.B. Härterformulierungen auf. Es eignen sich Carbonsäureanhydride mit sauren Estern (Carbonsäureanhydridhalbester), Flexibilisatoren, organische Phosphorverbindungen, Initiatoren und/oder Beschleuniger als Bestandteile der Härterformulierung. Als Beschleuniger können farblose Zn²⁺-Derivate enthalten sein, besonders bevorzugt weist die Härterformulierung Zinkoktoat als Beschleuniger auf, z.B. mit einer Konzentration von 10 Gewichts-% oder 24 Gewichts-%. Als Alternative zu Zinkoktoat kann eine andere Komplexverbindung von Zn²⁺ als Beschleuniger verwendet werden. Die Komplexverbindung weist z.B. organische ionische Liganden auf, beispielsweise auf Basis von Carbonsäuren oder von Alkoholen. Es können auch unterschiedliche Arten von Liganden in einer Komplexverbindung vorkommen. Beispiele für Liganden auf Basis von Carbonsäuren sind Stearat, Palmitat und Laurat.

Beispiele für Alkoholate sind längerkettige Alkoholate auf Basis von z.B. Butanol, Hexanol oder Oktanol.

Die Härterformulierung für die Epoxidgießharzmasse ist über mindestens 3 Monate lagerbar. Es handelt sich bei der Epoxidgießharzmasse um eine mehrkomponentige Vergussmasse, insbesondere um eine zweikomponentige Epoxidgießharzmasse, die eine A-Komponente und eine B-Komponente aufweist.

Bei der Herstellung von Konversionsmaterial werden allgemein mit Vorteil Polymerkomponenten verwendet, in die Leuchtstoffpartikel eingebettet sind und die mit den eingebrachten Leuchtstoffen bei Raumtemperatur mindestens 3 Monate lagerbar sind. Alternativ wird z.B. ein anorganisches Material wie Siliziumdioxid als Matrixmaterial verwendet. Für spezielle Anwendungen kann auch ein elektrisch leitfähiges Matrixmaterial wie ein TCO, z.B. ZnO oder ITO, als Matrixmaterial vorteilhaft sein.

Das Konvertermaterial kann auch mindestens ein Silikon aufweisen, das bevorzugt thermisch härtend und besonders bevorzugt additionsvernetzend ist. Als weitere Alternative oder zusätzliche Polymere sind beispielsweise Thermoplaste wie PMMI, PC, PA, PS, COP, COC oder TPX geeignet. Auch PMMA, das sich insbesondere mit organischen Leuchtstoffmolekülen auf einfache Weise versetzen lässt, kann zusätzlich oder alternativ zu den oben genannten Polymeren verwendet werden.

Die Verarbeitung von mit den Leuchtstoffpartikeln versetzten Massen, insbesondere von Epoxidharzen und/oder Silikonen, erfolgt vorzugsweise in Gießharz- oder Pressmassentechnologie oder durch Beschichtung. Die Verarbeitung erfolgt bei einer Mindesttemperatur von 80°C, bevorzugt bei einer Temperatur von größer als 120°C. Dies ist für eine rationelle und wirtschaftliche Herstellung des Konvertermaterials vorteilhaft.

Zur Herstellung stabiler und homogener Reaktionsharz- und Silikonbatches werden zum Beispiel Netzmittel, Entlüfter und/oder weitere Verarbeitungsmittel zugesetzt.

Das Konvertermaterial 5 weist Leuchtstoffpartikel auf. Bevorzugt sind Partikel aus Ce-dotiertem Granatmaterial (zum Beispiel YAG:Ce) mit einer Konzentration zwischen einschließlich 1 Gew% und einschließlich 30 Gew% enthalten. Die Leuchtstoffpartikel 6 liegen in Form von Nanopartikeln vor, mit einem d₅₀-Wert von beispielsweise kleiner als 25 nm, z.B. von 15 nm.

Der Leuchtstoff enthält beispielsweise zusätzlich zu den Nanopartikeln noch weitere Leuchtstoffpartikel 6 mit einem mittleren Durchmesser zwischen 10pm und 20pm oder zwischen 1µm und 20 µm.

Wie vorhergehend erwähnt, kann das Konvertermaterial Leuchtstoffpartikel aus oxidischem Granatmaterial aufweisen, das bevorzugt mit Ce dotiert ist. Alternativ oder zusätzlich zu dem auf einem Oxid basierenden Granatmaterial können auch Leuchtstoffpartikel mit Wirtsgittern auf Basis von Silikat, Sulfat, Sulfid, Phosphat oder Nitrid enthalten sein, wobei Leuchtstoffpartikel auf Basis von Nitrid bevorzugt sind. Zudem kann das Wirtsgitter des Leuchtstoffs mit unterschiedlichen Aktivator-Ionen dotiert sein, beispielsweise mit Europium (rotes Emissionsspektrum), Terbium (gelb-grünes Emissionsspektrum), mit Chrom, Mn oder mit Uranyl-Ionen. Bevorzugt weisen insbesondere die Leuchtstoffpartikel, die in Form von Nanopartikeln vorliegen, oxidische Wirtsgitter wie beispielsweise die bereits erwähnten Granatkristallstrukturen oder Spinellkristallstrukturen auf.

In einem Beispiel enthält der Leuchtstoff Nanopartikel mit einem Wirtsgitter aus einem Yttrium-Aluminium-Granat, das mit Cer als Aktivator dotiert ist. Ein Teil dieser Nanopartikel weist eine Cer-Konzentration von beispielsweise etwa 2 Atom% auf und ein weiterer Teil weist eine Cer-Konzentration von beispielsweise etwa 5 Atom% auf.

In einem weiteren Beispiel weist der Leuchtstoff Partikel mit einem Wirtsgitter auf, in dem mindestens zwei verschiedene Aktivatoren enthalten sind. Bevorzugt werden hierfür Atome verwendet, die als Aktivatoren ähnliche Ionenradien aufweisen. Beispielsweise weisen die Ionen auch gleiche Ladungen auf, was jedoch nicht zwingend erforderlich ist. Es ist beispielsweise ausgehend von einem Leuchtstoff mit einem dreiwertigen Ion als Aktivator grundsätzlich möglich, jeweils zwei dieser Aktivatoren durch drei zweiwertige Ionen zu ersetzen, um so ebenfalls eine ausgeglichene Ladung im Leuchtstoff zu erzielen. Als Beispiel wird ein Yttrium-Aluminium-Granat angegeben, z.B. mit Y₃Al₅O₁₂ als Wirtsgitter, das sowohl Ce als auch Cr als Aktivator enthält.

Generell können zu den Leuchtstoffen in Form von Nanopartikel sowohl organische als auch anorganische weitere Leuchtstoffe zugesetzt werden.

Ein Beispiel für grün-, gelb- und rot-leuchtende organische Leuchtstoffe sind Farbstoffmoleküle auf Perylen-Basis. Im UV, im Sichtbaren oder im Infraroten leuchtende Bauelemente können auch durch Beimischung von 4f-metallorganischen Verbindungen hergestellt werden. Insbesondere können rotleuchtende Bauelemente z. B. durch Beimischung von auf Eu³⁺ basierenden metallorganischen Chelaten realisiert werden. Infrarot strahlende Bauelemente, insbesondere mit blaues Licht aussendenden Halbleiterkörpern, können mittels Beimischung von 4f-Chelaten oder von Ti³⁺-dotiertem Saphir hergestellt werden.

Geeignete organische Leuchtstoffe für ein weißes lichtabstrahlendes erfindungsgemäßes Halbleiterbauelement sind Perylen-Leuchtstoffe wie z. B. BASF Lumogen F 083 für grüne Lumineszenz, BASF Lumogen F 240 für gelbe Lumineszenz und BASF Lumogen F 300 für rote Lumineszenz. Diese Farbstoffe lassen sich auf einfache Weise z. B. transparentem Epoxidharz oder einem Polymer-Hybridmaterial zusetzen. In Kombination mit mindestens einem anorganischen Leuchtstoff in Form von Nanopartikeln können sie eine besonders vorteilhafte Wirkung entfalten.

Ein weißes lichtabstrahlendes Bauelement läßt sich vorteilhafterweise dadurch herstellen, dass der Leuchtstoff so gewählt wird, dass eine von der Lichtquelle ausgesandte blaue Strahlung in komplementäre Wellenlängenbereiche, insbesondere Blau und Gelb, oder zu additiven Farbtripeln, z. B. Blau, Grün und Rot umgewandelt wird. Hierbei wird das gelbe bzw. das grüne und rote Licht über die Leuchtstoffe erzeugt. Der Farbton (Farbort in der CIE-Farbtafel) des dadurch erzeugten weißen Lichts kann dabei durch geeignete Wahl des/der Farbstoffes/e hinsichtlich Mischung und Konzentration variiert werden.

Im Folgenden werden mögliche Herstellungsverfahren und bevorzugte Ausgestaltungen von Verfahrensschritten zur Herstellung der in Form von Nanopartikeln vorliegenden Leuchtstoffe beschrieben. Diese werden beispielsweise in einem Sol-Gel-Verfahren, in einem epitaktischen Prozess (z.B. solvent evaporation epitaxy), mittels spezieller Sputtertechniken (z.B. radiofrequency magnetron sputtering), mittels Hydrothermalsynthesen oder mittels Fällungsverfahren in einem wässrigen Milieu hergestellt.

Die Fällungsverfahren in einem wässrigen Milieu können mit oder ohne Kalzinierungen erfolgen, wobei eine Kalzinierung in diesem Zusammenhang bevorzugt bei einer Temperatur von größer als 500°C erfolgt.

In Sol-Gel-Verfahren werden Precursor-Verbindungen der für die Leuchtstoff-Nanopartikel benötigten Elemente in einer Lösung mit hoher Verdünnung bereitgestellt. Der Anteil der Leuchtstoff-Nanopartikel beträgt z.B. 5 Gewichts-%. Alternativ sind auch höhere Konzentrationen möglich, beispielsweise 85 Gewichts-%.

Die Lösung weist bevorzugt mindestens ein Alkohol als Lösungsmittel auf. Sie wird zweckmäßigerweise z.B. mit Essigsäure angesäuert und mit Wasser versetzt. Nachfolgend wird die Lösung beispielsweise in einem alkalischen Medium unter kontrollierten Vorgaben der Zeit und der Temperatur hydrolytisch gefällt. Die dabei erzeugten Partikel werden nachfolgend gewaschen und getrocknet. Sie können bei einer Temperatur von bevorzugt größer als 500°C geglüht werden.

Die Größe, die Verteilung, die Form und die Morphologie der durch ein solches Sol-Gel-Verfahren hergestellten Leuchtstoffpartikel hängt teilweise stark von verschiedenen Parametern ab. Zu derartigen Parametern zählen der Verdünnungsgrad der Lösung, die gewählten pH-Werte, die Auswahl von Temperatur und Dauer für die Fällungsreaktion, und die Reinheit der Ausgangskomponenten und Lösungsmittel. Es wird bevorzugt ein hochgradig von CO₂ und Ionen befreites Wasser verwendet.

Die Precursor-Verbindungen reagieren miteinander in der Lösung in Abhängigkeit von der Konzentration, des pH-Wertes und der Temperatur der Lösung, und bilden in einer Art Kondensationsreaktion die Leuchtstoffpartikel. Nachfolgend können die Leuchtstoffpartikel z.B. mittels eines Glühverfahrens und/oder eines Luftstroms behandelt und getrocknet werden.

Mit den oben genannten Parametern wie Verdünnungsgrad der Lösung, pH-Werte, Auswahl von Temperatur und Dauer für die Fällungsreaktion sowie Reinheit der Ausgangskomponenten und Lösungsmittel lässt sich auch die Bildung von Agglomeraten zumindest teilweise steuern.

Auch die Behandlung mittels eines Glühverfahrens und/oder eines Luftstroms bietet Möglichkeiten, die Bildung von Agglomeraten gezielt zu beeinflussen. Mit einem Glühverfahren und einem Luftstrom kann die Bildung von Agglomeraten weitgehend verhindert werden. Es kann jedoch auch die gezielte Bildung von Agglomeraten beeinflusst werden, beispielsweise durch Wahl von Temperatur und Dauer sowie Ablauf des Glühverfahrens oder durch die Art, Intensität und Temperatur des Luftstrahls.

Die Bildung von Agglomeraten lässt sich zudem beim Einbringen der Leuchtstoffpartikel in ein Matrixmaterial gezielt steuern. Wenn die Partikel z.B. in eine A-Komponente einer Vergussmasse eingebracht werden, erfolgt dies bevorzugt unter starkem Durchmischen und Rühren der Masse. Je weniger stark die Masse gerührt und durchmischt wird, desto mehr und größere Agglomerate können sich bilden. Wichtig sind hierbei Rühr-Frequenz und aufgewandte Kraft beim Mischen.
Mit den oben beschriebenen Sol-Gel-Verfahren lassen sich beispielsweise Leuchtstoffpartikel herstellen, die ein Metalloxid aufweisen und mit Seltenerdmetallen aktiviert sind. Die Leuchtstoffpartikel sind insbesondere in Form von Nanopartikeln herstellbar. Die Precursor-Verbindungen der Wirtsgitter- und Aktivatorelemente des herzustellenden Leuchtstoffes werden in einer n-Butoxid/Butanol-Lösung bereitgestellt, die nachfolgend einer Acetolyse unterzogen wird, sodass sich der pH-Wert der Lösung vom Basischen zum Sauren ändert.

Durch einen solchen Prozess lässt sich beispielsweise Yttriumoxid (Y₂O₃) herstellen, das mit mindestens einem Seltenerdmetall aktiviert ist. Geeignete Seltenerdmetalle sind beispielsweise Europium, Terbium, Thulium, Cer, Gadolinium und/oder Erbium.

Alternativ kann als Precursor-Lösung auch eine wässrige Lösung bereitgestellt werden, die Metallnitrate enthält, wobei die Metalle die jeweiligen Konstituenten der herzustellenden Leuchtstoffpartikel sind. Unter Verwendung einer derartigen wässrigen Lösung lassen sich insbesondere keramische Leuchtstoffpartikel herstellen. Der wässrigen Lösung wird hierzu Harnstoff hinzugefügt. Nachfolgend wird die Precursor-Lösung erhitzt. Geeignete Temperaturen liegen beispielsweise zwischen einschließlich 80° C und 130° C. Je höher die Temperatur, desto größer werden die so hergestellten Leuchtstoffpartikel. Bei einer Temperatur zwischen 90° C und 110° C sind beispielsweise ZnGa₂O₄-Partikel mit einer durchschnittlichen Partikelgröße zwischen 15 nm und 18 nm herstellbar.

Verfahren der oben beschriebenen Art sind beispielsweise in der EP 1 227 139 A1 oder der US 5,637,258 beschrieben, deren Offenbarungsgehalt hiermit durch Rückbezug aufgenommen wird.

Die als Nanopartikel vorliegenden Leuchtstoffe werden als wässrige Lösungen, als Suspensionen, als Sole oder als Gele bereitgestellt, beispielsweise in oder mit organischen Lösungsmitteln. Die Nanopartikel weisen in diesen Formen Konzentrationen von bis zu 98 Gewichts% auf. Als organische Lösungsmittel eignen sich beispielsweise Alkohole, Toluol, Xylol, Ester, Aldehyde, Ketone, DMF, DMSO, Kohlenwasserstoffe oder CS₂. Alternativ werden die Nanopartikel als ein Pulver bereitgestellt. Ausgehend von derartigen Formen können die Leuchtstoffpartikel grundsätzlich in das Konvertermaterial eingearbeitet werden.

Alternativ können die oben genannten Suspensionen wie insbesondere die wässrigen Lösungen, Sole oder die Gele also solche bereits als Konvertermaterial verwendet werden und auf die Strahlungsquelle aufgebracht werden.

Wie im allgemeinen Teil beschrieben kann die Suspension weitere Zusätze enthalten. Beispiele für derartige Zusätze sind Haftvermittler, Entlüfter, Fließadditive, und/oder Füllstoffe. Mittels den Zusätzen wird beispielsweise eine gelartige Viskosität zwischen 10000 und 20000 mPas eingestellt. Zusätzlich oder alternativ kann die Suspension thixotrop sein. Als Füllstoff wird z.B. Aerosil 200 verwendet.

Das Aufbringen des als Suspension vorliegenden Lumineszenzkonversionsmaterials erfolgt beispielsweise mittels eines Dispensers mit einem Dosierventil (Dispensen), mittels eines Druckverfahrens, bevorzugt mittels eines Tintenstrahldruckverahrens und/oder mittels Spin-Coating.

Das Dispensen und insbesondere auch die Verwendung eines Tintenstrahldruckverfahrens sind geeignet, die Suspension in kleinen Tropfen aufzubringen und durch die Anordnung der Tropfen gezielte Strukturen aufzubringen. Zum Aufbringen derartiger Tropfen eignet sich insbesondere die Verwendung eines DOD-Druckers ("Drop on demand"-Drucker). Die Strukturen sind beispielsweise zusammenhängend. Alternativ weisen die Strukturen eine Vielzahl separater Teilbereiche mit Lumineszenzkonverter auf. Diese Teilbereiche sind mit Vorteil in geordneter Form aufgebracht, bevorzugt in einer matrixartigen Form oder in einer Matrix.

Das in Figur 2 dargestellte Ausführungsbeispiel eines erfindungsgemäßen Bauelements unterscheidet sich von dem der Figur 1 dadurch, dass der Halbleiterkörper 1 und Teilbereiche der elektrischen Anschlüsse 2 und 3 anstatt von einer wellenlängenkonvertierenden Reaktionsharzmasse von einer transparenten oder transluzenten Umhüllung 10 umschlossen sind. Diese Umhüllung 10 bewirkt keine Wellenlängenänderung der von dem Halbleiterkörper 1 ausgesandten Strahlung und besteht beispielsweise aus einem in der Leuchtdiodentechnik herkömmlich verwendeten Epoxid-, Silikon- oder Acrylatharz oder aus einem anderen geeigneten strahlungsdurchlässigen Material wie z. B. anorganisches Glas.

Auf diese Umhüllung 10 ist eine Schicht 4 aufgebracht, die aus einem wellenlängenkonvertierenden Konvertermaterial besteht oder ein derartiges Material aufweist. Das Konvertermaterial kann wie im Zusammenhang mit dem ersten Ausführungsbeispiel zusammengesetzt und beschaffen sein. Wie in der Figur 2 dargestellt, bedeckt die Schicht 4 die gesamte Oberfläche der Umhüllung 10. Ebenso ist es möglich, dass die Schicht 4 nur einen Teilbereich dieser Oberfläche bedeckt. Die Schicht 4 besteht beispielsweise aus einer Reaktionsharzmasse, die auf einem transparenten Epoxidharz basiert und die mit Leuchtstoffpartikeln 6 versetzt ist. Als Reaktionsharzmasse eignet sich hier beispielsweise die im Zusammenhang mit dem ersten Ausführungsbeispiel beschriebene. Auch hier eignet sich als Leuchtstoff für ein weiß leuchtendes Halbleiterbauelement bevorzugt YAG:Ce oder YAG:Ce-basierte Leuchtstoffe.

Bei dem in Figur 3 dargestellten Bauelement, sind der erste und zweite elektrische Anschluss 2,3 eines Leadframes in einen Gehäusegrundkörper 8 mit einer Ausnehmung 9 eingebettet. Die Ausnehmung 9 ist mit dem vorhergehend beschriebenen Konvertermaterial 5 gefüllt.

Der Gehäusegrundkörper ist vorzugsweise aus reflektierendem Kunststoff vorgefertigt. Unter "vorgefertigt" ist zu verstehen, dass der Gehäusegrundkörper 8 bereits an den Anschlüssen 2,3 beispielsweise mittels Spritzgießen oder Spritzpressen fertig ausgebildet ist, bevor der Lumineszenzdiodenchip 1 auf den Anschluss 2 montiert wird. Der Gehäusegrundkörper 8 besteht beispielsweise aus einem mit weißem, reflektierendem Füllstoff gefüllten Kunststoff und die Ausnehmung 9 ist hinsichtlich ihrer Form als Reflektor 17 für die vom Halbleiterkörper im Betrieb ausgesandte Strahlung (ggf. durch geeignete Beschichtung der Innenwände der Ausnehmung 9) ausgebildet. Solche Gehäusegrundkörper 8 werden insbesondere bei auf Leiterplatten oberflächenmontierbaren Leuchtdiodenbauelementen verwendet. Sie werden vor der Montage der Halbleiterkörper 1 auf ein die elektrischen Anschlüsse 2,3 aufweisendes Leiterband (Leadframe) z. B. mittels Spritzgießen aufgebracht.

Die Ausnehmung 9 ist bevorzugt mit einer Reaktionsharzmasse 5 zumindest teilweise gefüllt. Als Reaktionsharzmasse eignen sich hier beispielsweise die im Zusammenhang mit dem ersten Ausführungsbeispiel beschriebenen.

Alternativ kann die Ausnehmung mit transparenter oder transluzenter Masse gefüllt sein, die keine oder einer erste Wellenlängenkonversion übernimmt und auf der eine wellenlängenkonvertierende Schicht entsprechend der Schicht 4 von Figur 3 aufgebracht ist.

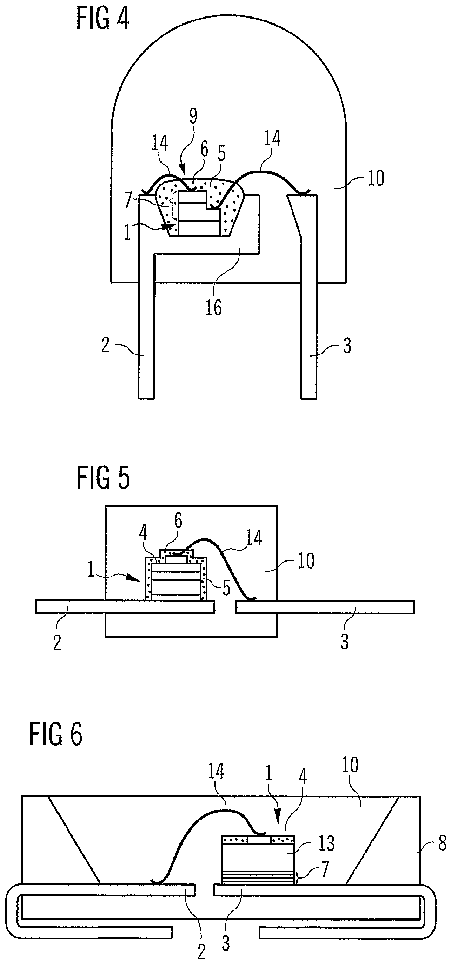

In Figur 4 ist eine sogenannte Radialdiode dargestellt. Hierbei ist der strahlungsemittierende Halbleiterkörper 1, z.B. ein Lumineszenzdiodenchip, in einem als Reflektor ausgebildeten Teil 16 des ersten elektrischen Anschlusses 2 beispielsweise mittels Löten oder Kleben befestigt. Derartige Gehäusebauformen sind in der Leuchtdiodentechnik bekannt und bedürfen von daher keiner näheren Erläuterung.

Die freien Oberflächen des Halbleiterkörpers 1 sind unmittelbar von einem Konvertermaterial 5 mit Leuchtstoffpartikeln 6 bedeckt, die wiederum von einer weiteren transparenten Umhüllung 10 umgeben ist. Als Konvertermaterial eignen sich hier beispielsweise wieder die im Zusammenhang mit dem ersten Ausführungsbeispiel beschriebenen Konvertermaterialien.

Der Vollständigkeit halber sei an dieser Stelle angemerkt, dass selbstverständlich auch bei der Bauform nach Figur 4 analog zu dem Bauelement gemäß Figur 1 eine einstückige Umhüllung, bestehend aus einem Konvertermaterial 5 mit gehärteter Reaktionsharzmasse mit Leuchtstoffpartikel 6, oder ein anderes im Zusammenhang mit dem in Figur 1 dargestellten Ausführungsbeispiel angegebenes Konvertermaterial verwendet sein kann.

Bei dem Ausführungsbeispiel von Figur 5 ist eine Schicht 4 aus einem wellenlängenkonvertierenden Konvertermaterial direkt auf den Halbleiterkörper 1 aufgebracht. Der Halbleiterkörper 1 und Teilbereiche der elektrischen Anschlüsse 2,3 sind von einer weiteren transparenten Umhüllung 10 umschlossen, die keine Wellenlängenänderung der durch die Schicht 4 hindurchgetretenen Strahlung bewirkt und beispielsweise aus einem in der Leuchtdiodentechnik verwendbaren transparenten Epoxidharz oder aus Glas gefertigt ist. Die Konversionsschicht 4 kann z.B. so wie im Zusammenhang mit dem zweiten Ausführungsbeispiel beschrieben beschaffen sein.

Solche, mit einer Konversionsschicht 4 versehenen Halbleiterkörper 1 können vorgefertigt werden und wahlweise in sämtliche aus der Leuchtdiodentechnik bekannten Gehäusebauformen (z. B. SMD-Gehäuse, Radial-Gehäuse (man vergleiche Figur 4) eingebaut werden. Die Konversionsschicht 4 muss nicht zwangsweise die gesamte freie Oberfläche des Halbleiterkörpers 1 bedecken, sondern sie kann auch nur Teilbereiche des Halbleiterkörpers überspannen. Die Konversionsschicht 4 kann beispielsweise bereits im Waferverbund vor dem endgültigen Vereinzeln des Wafers zu einer Vielzahl von Halbleiterkörpern auf diese aufgebracht werden. Die Konversionsschicht 4 weist weiterhin vorzugsweise eine konstante Dicke auf.

Bei dem in Figur 6 beschriebenen Ausführungsbeispiel ist innerhalb eines Gehäusegrundkörpers 8 ein umgedrehter (d.h. Flip-Chip-montierter) Halbleiterkörper 1 in Form eines Lumineszenzdiodenchips auf dem Leadframe 2,3 befestigt. Dieser weist ein für die von der aktiven Schichtenfolge 7 ausgesandte Strahlung durchlässiges Substrat 13 auf, das zur besseren Strahlungsauskopplung strukturiert sein kann (nicht gezeigt). Auf der von der aktiven Schichtenfolge 7 abgewandten Seite des Substrats 13 ist eine Konversionsschicht 4 aus einem wellenlängenkonvertierenden Konvertermaterial aufgebracht, das durchweg im Wesentlichen die gleiche Dicke aufweist. Diese kann, anders als in Figur 6 dargestellt, auch über die Seitenflächen (Flanken) gezogen sein. Diese Konversionsschicht ist vorzugsweise vor der Montage des Halbleiterkörpers 1 auf diesem aufgebracht worden. Nach Montage des Chips in der Ausnehmung des Gehäusegrundkörpers wird dieser vorzugsweise mit einer weiteren Kunststoffmasse umhüllt.

Bei den in Figur 5 und 6 dargestellten Ausführungsbeispielen weist das Konvertermaterial beispielsweise Leuchtstoffe mit einem relativ hohen Anteil von z.B. 75 Gewichts% oder 80 Gewichts% auf. Alternativ ist hier z.B. auch ein Anteil von 50 Gewichts% oder 55 Gewichts% möglich. Derartig hohe Anteile von Leuchtstoffen sind bei Konvertermaterialien im Rahmen der Erfindung unabhängig von der konkreten Applikation grundsätzlich möglich.

Bei sämtlichen der oben beschriebenen Bauelemente kann zur Optimierung des Farbeindrucks des abgestrahlten Lichts sowie zur Anpassung der Abstrahlcharakteristik die Reaktionsharzmasse 5, ggf. die transparente oder transluzente Umhüllung 10 lichtstreuende Partikel, vorteilhafterweise sogenannte Diffusoren aufweisen. Beispiele für derartige Diffusoren sind mineralische Füllstoffe, insbesondere CaF₂, TiO₂, SiO₂, CaCO₃ oder BaSO₄ oder auch organische Pigmente. Diese Materialien können auf einfache Weise Reaktionsharzen, wie Epoxidharzen, zugesetzt werden. Sie weisen bevorzugt einen d₅₀-Wert von größer als oder gleich 100 nm auf.

Die Lumineszenzdiodenchips der Bauelemente werden z.B. im Pulsbetrieb betrieben. Zudem können die Bauelemente in Vorrichtungen verwendet werden, in denen optische Schaltprozesse erfolgen. Leuchtstoffe in Form von Nanopartikeln haben kürzere Ansprech- und Abklingzeiten als Leuchtstoffe in Form von deutlich größeren Partikeln. Dadurch eignen sich derartige Leuchtstoffe grundsätzlich auch mit Vorteil für einen Pulsbetrieb oder für Schaltprozesse mit kurzen Schaltzeiten.

Der Halbleiterkörper 1 kann bei allen oben beschriebenen Bauelementen ein blaues lichtabstrahlender Lumineszenzdiodenchip sein, dessen Emissionsspektrum unterhalb einer Wellenlänge von 520 nm liegt. Es ist auch möglich, dass die von dem Lumineszenzdiodenchip emittierte Strahlung teilweise oder vollständig im ultravioletten Bereich liegt. Allgemein emittiert der Lumineszenzdiodenchip mit Vorteil eine elektromagnetische Strahlung aus dem Bereich zwischen einschließlich 360 nm und einschließlich 500 nm.

Bei einer blauen LED ist die emittierte Strahlung bevorzugt aus einem Bereich zwischen 440 nm und 475 nm, innerhalb dem das Emissionspektrum zumindest ein lokales Intensitätsmaximum aufweist. Der Leuchtstoff 6 (z. B. YAG:Ce) wandelt einen Teil der Strahlung des blau emittierenden Lumineszenzdiodenchips in gelbes Licht um, so dass das Bauelement insgesamt weißes Licht aussendet.

Von der vom Halbeiterkörper 1 ausgesandten Primärstrahlung wird in dem vorhergehend beschriebenen Beispiel nur ein Teil in einen längerwelligen Wellenlängenbereich konvertiert, so dass als Mischfarbe weißes Licht entsteht. Alternativ können zwei Leuchtstoffe verwendet sein, von denen einer rotes Licht und einer grünes Licht erzeugt, um somit insgesamt die Farbe Weiß aus drei Wellenlängenbereichen (additives Farbtripel aus Blau, Grün und Rot) zu erzeugen. Dabei kann z.B. nur einer der Leuchtstoffe Leuchtstoffpartikel 6 in Form von Nanopartikeln aufweisen. Alternativ können beide Leuchtstoffarten Nanopartikel umfassen. Zusätzlich zu den Nanopartikeln kann einer der Leuchtstoffe oder können beide Leuchtstoffe größere Leuchtstoffpartikel aufweisen, mit einem d₅₀-Wert gemessen in Q₃ von beispielsweise 8 µm oder mehr. Der als Nanopartikel enthaltene Anteil der Leuchtstoffe wirkt dann einer Sedimentation der übrigen Leuchtstoffanteile mit Vorteil entgegen. Es ist auch möglich, die gesamte Primärstrahlung mittels zwei oder mehr Leuchtstoffen zu konvertieren, um weißes Licht zu erzeugen.

Neben weißem Licht kann ein Leuchtstoff oder können mehrere Leuchtstoffe und deren jeweilige Konzentration auch derart gewählt werden, dass grundsätzlich beliebige Farborte des CIE-Diagramms mit dem optischen Bauelement realisiert werden können. Es kann hierfür auch eine andere als eine blau emittierende Primärstrahlungsquelle verwendet werden, beispielsweise ein Lumineszenzdiodenchip, der Strahlung aus dem UV-Bereich oder aus dem grünen Bereich emittiert.

Bei den Bauelementen gemäß der Erfindung können durch Wahl der Leuchtstoffe und/oder Veränderung der Leuchtstoffkonzentration(en) in der Reaktionsharzmasse oder dem Konvertermaterial der CIE-Farbort des Mischlichtes auf einfache Weise verändert werden. Eine gezielte und möglichst genaue Einstellung des Farbortes ist mit als Nanopartikel vorliegenden Leuchtstoffen besonders gut möglich, mit denen sich besonders dünne Polymerschichten oder Glasschichten herstellen lassen. Durch die Verwendung von Nanopartikeln sind trotz dünner Konversionsschichten keine oder kaum Einbußen in der Homogenität der konvertierten Strahlung zu befürchten. Der Farbort lässt sich durch Einstellung der Dicke der dünnen Konversionsschicht, Wahl der Leuchtstoffkonzentrationen und Kombination verschiedener Leuchtstoffe einstellen.

Die beschriebenen Bauelemente sind mit Vorteil z.B. derart ausgebildet, dass sie Qualitätsstandards im Automobilelektronikbereich erfüllen.

Bei einem beispielhaften Verfahren zum Herstellen der Reaktionsharzmasse werden bevorzugt zunächst die in Form von Nanopartikeln vorliegenden Leuchtstoffpartikel dem Konvertermaterial zugesetzt und werden nachfolgend weitere Leuchtstoffpartikel eingemischt, die einen d₅₀-Wert von beispielsweise 5 µm oder mehr als 5 µm, z.B. von 15 µm aufweisen.

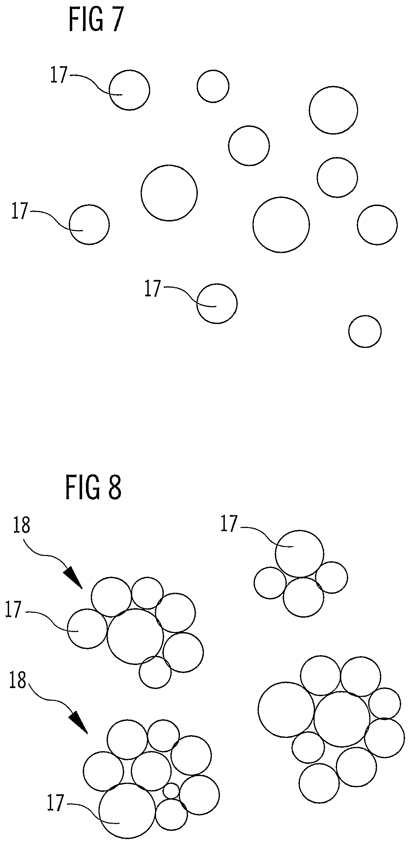

In Figur 7 sind beispielhaft Nanopartikel 17 eines oder mehrerer Leuchtstoffe dargestellt. Die dargestellten Nanopartikel 17 sind nicht miteinander agglomeriert, sondern jedes der Nanopartikel 17 ist jeweils von den übrigen Nanopartikeln beabstandet.

Alternativ ist es jedoch auch mit Vorteil möglich, die Leuchtstoffpartikel teilweise oder vollständig gezielt in Form von Agglomeraten 18 bereitzustellen, wie sie beispielhaft in Figur 8 dargestellt sind. Diese Agglomerate 18 setzen sich aus mindestens zwei Primärpartikeln zusammen, wobei die Primärpartikel bevorzugt die Nanopartikel 17 des Leuchtstoffes sind. Auch die Agglomerate 18 können einen Mediandurchmesser d₅₀ von kleiner als oder gleich 100 nm aufweisen, wobei der Mediandurchmesser anhand Q₀ oder Q₃ ermittelt wird. Beispielsweise beträgt d₅₀ für die Agglomerate 60 nm oder 30 nm. Zum Ermitteln der Durchmesser kann beispielsweise das Volumen der Agglomerate oder eine projizierte Fläche der Agglomerate 18 gemessen werden. Aus diesen Werten lässt sich unter der Annahme, dass die Agglomerate 18 kugelförmig sind, der entsprechende Durchmesser ermitteln.

Die Agglomerate 18 können jeweils Leuchtstoffpartikel von nur einem einzigen Leuchtstoff aufweisen. Es ist jedoch grundsätzlich auch möglich, dass Leuchtstoffpartikel mehrerer unterschiedlicher Leuchtstoffe in gemeinsamen Agglomeraten 18 miteinander verbunden sind. Dies kann bei lichtemittierenden Bauelementen mit Konvertermaterial für die Erzeugung eines homogenen Farbeindruck vorteilhaft sein.

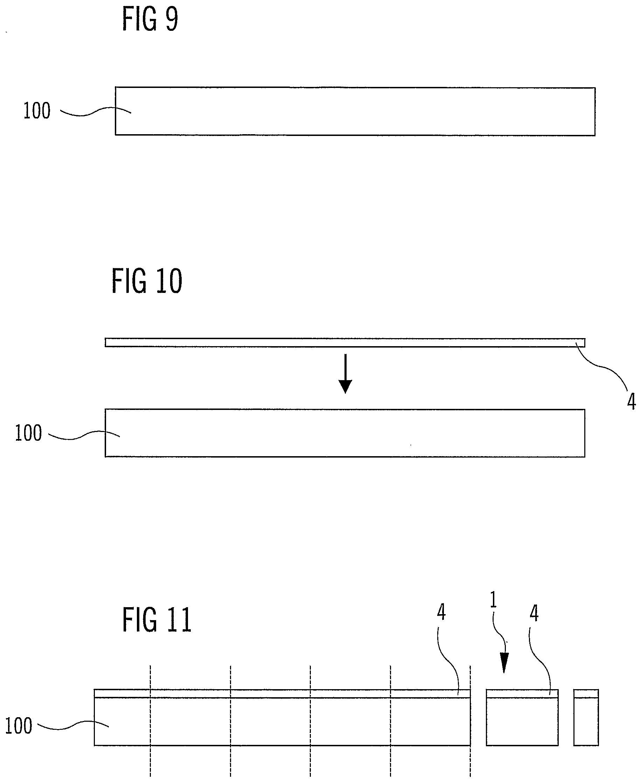

Ein beispielhaftes Verfahren zum Herstellen eines lichtabstrahlenden optischen Bauelements ist in den Figuren 9 bis 11 illustriert. Bei dem Verfahren wird ein Schichtenverbund 100 bereitgestellt, siehe Figur 9. Der Schichtenverbund weist eine Mehrzahl von Lichtemissions-Strukturen, z.B. eine Mehrzahl von Lumineszenzdioden-Strukturen in einem gemeinsamen Verbund auf. Bei dem Schichtenverbund 100 kann es sich insbesondere um einen Halbleiterwafer handeln, der eine aktive Schicht oder Schichtenfolge aufweist, die geeignet ist, elektromagnetische Strahlung zu emittieren.

Bei dem Verfahren wird zudem eine Konversionsschicht 4 bereitgestellt, siehe Figur 10. Die Konversionsschicht 4 weist beispielsweise eine im Wesentlichen konstante Dicke von etwa 40 µm auf. Die Konversionsschicht 4 liegt in Form einer Folie vor, das heißt, sie ist insbesondere flexibel. Sie weist ein geeignetes Matrixmaterial auf, beispielsweise eine Polymermasse, in der die Leuchtstoffpartikel eingebettet sind. Die vorgefertigte Konversionsschicht 4 wird beispielsweise im Wesentlichen ganzflächig auf eine Hauptfläche des Schichtenverbundes 100 aufgebracht, was in Figur 10 durch einen Pfeil angedeutet ist. Die Konversionsschicht 4 kann beispielsweise auf den Schichtenverbund 100 aufgeklebt oder auflaminiert werden. Beim Auflaminieren wird durch Wärmeeinwirkung eine Haftung zwischen der Konversionsschicht 4 und dem Schichtenverbund 100 ausgebildet.

Vor oder nach dem Aufbringen der Konversionsschicht 4 auf dem Schichtenverbund 100 kann die Konversionsschicht 4 optional strukturiert werden. Beispielsweise kann die Konversionsschicht mit geeigneten Löchern versehen werden, so dass durch die aufgebrachte Konversionsschicht hindurch zum Beispiel elektrische Anschlussflächen des Schichtenverbundes 100 zugänglich sind. Durch eine geeignete Strukturierung der Konversionsschicht 4 kann zudem der resultierende Farbeindruck und die Abstrahlcharakteristik der herzustellenden Bauelemente gezielt eingestellt werden. Hierzu kann die Konversionsschicht 4 z.B. derart strukturiert werden, dass die Teile, die jeweils einem Halbleiterkörper zugeordnet sind, in den Außenbereichen Strukturen aufweisen, bei denen die Konversionsschicht abgedünnt und/oder partiell entfernt ist.

Der Schichtenverbund 100 wird zu einer Mehrzahl von Halbleiterkörpern 1 vereinzelt. Auch die Konversionsschicht 4 wird entsprechend in eine Mehrzahl von Teilen vereinzelt. Bevorzugt werden der Schichtenverbund 100 und die Konversionsschicht 4 nach dem Aufbringen der Konversionsschicht gemeinsam vereinzelt, siehe Figur 11. Dadurch weist jeder vereinzelte Halbleiterkörper 1 eine Konversionsschicht 4 auf.

Alternativ ist es auch möglich, den Schichtenverbund 100 vor dem der Konversionsschicht 4 zu vereinzeln. Beispielsweise wird der Schichtenverbund 100 zu Halbleiterkörpern 1 vereinzelt, bevor die Konversionsschicht aufgebracht wird. In diesem Fall wird die Konversionsschicht auf die vereinzelten Halbleiterkörper aufgebracht oder die Halbleiterkörper werden auf die Konversionsschicht aufgebracht. Dies erfolgt bevorzugt, bevor die Konversionsschicht 4 vereinzelt wird.

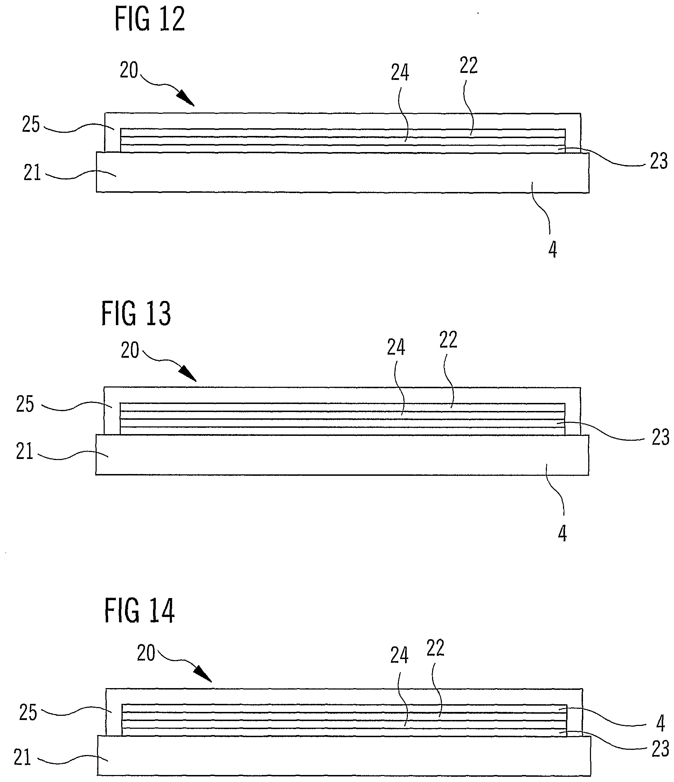

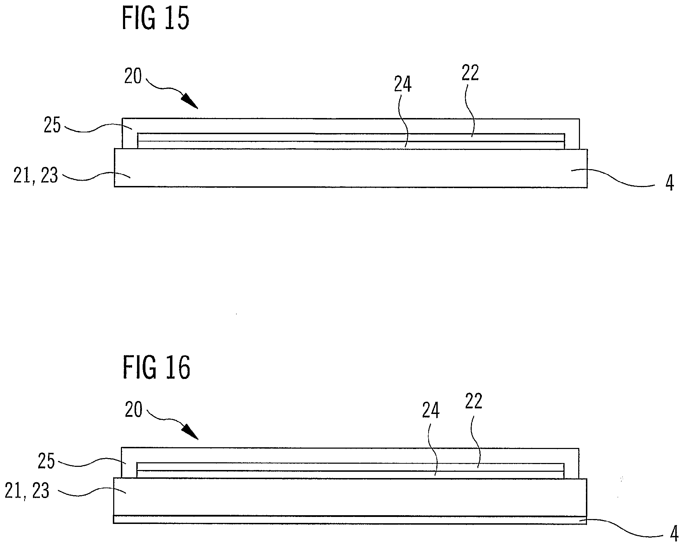

Die in den Figuren 12 bis 15 dargestellten Licht emittierenden optoelektronischen Bauelemente sind jeweils organische Lumineszenzdioden 20. Während bei den in den Figuren 12 bis 15 dargestellten organischen Lumineszenzdioden 20 jeweils mindestens ein Leuchtstoff innerhalb der Leuchtdiode selbst integriert ist, ist in Figur 16 ein Beispiel für eine organische Leuchtdiode dargestellt, bei der auf eine Außenfläche Konvertermaterial aufgebracht ist.

Die organischen Lumineszenzdioden 20 weisen ein Substrat 21 auf, auf dem beispielsweise eine erste Elektrodenschicht 23, eine organische lumineszierende Schicht 24 sowie eine zweite Elektrodenschicht 22 aufgebracht sind. Die Elektrodenschichten 22, 23 sowie die organische lumineszierende Schicht 24 sind mittels einer Umkapselung 25 eingekapselt. Diesbezüglich stellen die in den Figuren 15 und 16 dargestellten Ausführungsbeispiele Ausnahmen dar, bei denen die erste Elektrodenschicht 22 gleichzeitig auch als Substrat 21 fungiert und somit nicht mittels der Umkapselung 25 eingekapselt ist.

Die organische lumineszierende Schicht 24 weist organische Moleküle und/oder Polymere als aktive Substanzen auf. Mögliche Aufbauten von organischen Lumineszenzdioden und Zusammensetzungen organischer lumineszierender Schichten sind dem Fachmann allgemein bekannt und werden von daher an dieser Stelle nicht genauer beschrieben.

Der in den Figuren 12 bis 16 dargestellte Aufbau der Leuchtdioden ist jeweils als beispielhafter Aufbau einer organischen Lumineszenzdiode zu verstehen. Die in den Ausführungsbeispielen beschriebenen Prinzipien im Zusammenhang mit der Integration von Leuchtstoffpartikeln können selbstverständlich auch bei Leuchtdioden mit deutlich unterschiedlichem Aufbau angewandt werden, auch wenn Merkmale der in den Figuren 12 bis 16 dargestellten Leuchtdioden nicht oder auf eine andere Weise realisiert sind.

Bei dem in Figur 12 dargestellten Ausführungsbeispiel weist das Substrat 21 Leuchtstoffpartikel auf. Beispielsweise enthält das Substrat 21 eine Konversionsschicht 4 oder das gesamte Substrat 21 ist als eine Konversionsschicht 4 ausgebildet. Bei dieser organischen Lumineszenzdiode 20 wird eine in der organischen Schicht 24 erzeugte elektromagnetische Strahlung durch das Substrat 21 transmittiert und dabei teilweise oder vollständig konvertiert.

Zusätzlich oder alternativ ist es auch möglich, Leuchtstoffpartikel in andere Bestandteile der organischen Lumineszenzdiode 20 zu integrieren. Beispielsweise kann die Umkapselung 25 oder die organische lumineszierende Schicht 24 Leuchtstoffpartikel aufweisen. Dies ist grundsätzlich auch bei den Elektrodenschichten 22, 23 möglich, beispielsweise wenn diese ein elektrisch leitfähiges Polymer aufweisen.

Weiterhin ist es möglich, dass die Lumineszenzdiode 20 mindestens zwei Teile aufweist, in die jeweils Leuchtstoffpartikel eingebracht sind. Die Teile der Lumineszenzdiode weisen z.B. unterschiedliche Leuchtstoffe oder Leuchtstoff-Mischungen auf. Beispielsweise weist das Substrat 21 eine erste Leuchtstoffsorte und die Umkapselung 25 eine zweite Leuchtstoffsorte auf, sodass die in der organischen Schicht 24 erzeugte elektromagnetische Strahlung in der Umkapselung zu Licht eines ersten Wellenlängenbereiches und im Substrat zu Licht eines zweiten Wellenlängenbereiches konvertiert wird. Eine derartige Leuchtdiode 20 kann zwei Hauptabstrahlseiten aufweisen, eine auf Seite des Substrates 21 und eine weitere auf Seite der Umkapselung 25, wobei auf den beiden Hauptabstrahlseiten jeweils unterschiedlich farbiges Licht emittiert wird.

Die in den Figuren 13, 14 und 16 dargestellten Bauelemente sind Beispiele für organische Lumineszenzdioden 20, bei denen auf dem Substrat 21 mindestens eine Konversionsschicht 4 aufgebracht ist. Bei dem in Figur 13 dargestellten Ausführungsbeispiel ist die Konversionsschicht 4 im Inneren der Leuchtdiode 20 unmittelbar auf dem Substrat 21 aufgebracht. Auch bei dem in Figur 14 dargestellten Ausführungsbeispiel ist die Konversionsschicht im Inneren der Lumineszenzdiode 20 angeordnet, diesmal jedoch auf einer vom Substrat 21 abgewandten Seite der organischen lumineszierenden Schicht 24. Beispielsweise ist die Konversionsschicht 4 zwischen der zweiten Elektrodenschicht 22 und der Umkapselung 25 angeordnet. Bei dem in Figur 16 dargestellten Ausführungsbeispiel ist auf einer Außenfläche des Substrates 21, die dem Inneren der Lumineszenzdiode 20 abgewandt ist, eine Konversionsschicht 4 aufgebracht.

Die Konversionsschicht 4 weist beispielsweise eine Dicke von kleiner als oder gleich 5 µm auf. Sie ist flexibel und wird in Form einer Folie großflächig im Inneren einer Leuchtdiode oder auf einer Außenfläche der Leuchtdiode aufgebracht. Dies eignet sich insbesondere für flexibel organische Lumineszenzdioden, die beispielsweise für ein Aufbringen auf unebene Flächen oder für zusammenrollbare Displays oder Beleuchtungseinheiten vorgesehen sind. Erst durch die Verwendung von Leuchtstoffen in Form von Nanopartikeln wird die Herstellung derart dünner Konversionsschichten 4 praktikabel. Bei den organischen Lumineszenzdioden, die in der Regel sehr dünn ausgebildet sind, wird die Dicke somit mit Vorteil nur unwesentlich durch die Konversionsschicht 4 erhöht.

Das in Figur 15 dargestellte Ausführungsbeispiel ähnelt dem vorhergehend anhand Figur 12 erläuterten Ausführungsbeispiel. Ein Unterschied ist, dass das Substrat 21 gleichzeitig auch als Elektrodenschicht 23 fungiert. Es handelt sich dabei zum Beispiel um ein Polymerelektrodensubstrat, in das im Unterschied zu herkömmlichen Polymerelektrodensubstraten Leuchtstoffpartikel eingebracht sind. Somit wirkt das Substrat 21 zumindest teilweise sowohl als Elektrode als auch als Konversionsschicht 4.

Die in den Ausführungsbeispielen beschriebenen Licht emittierenden optoelektronischen Bauelemente sind beispielsweise für eine Verwendung zur Allgemeinbeleuchtung vorgesehen. Die Wellenlängenbereiche der Primärstrahlungsquellen sowie der verwendeten Leuchtstoffe und das Mischungsverhältnis elektromagnetischer Strahlung unterschiedlicher Wellenlängenbereiche ist derart aufeinander abgestimmt, dass ein für die Allgemeinbeleuchtung erwünschter resultierender Farbort des Bauelements eingestellt ist. Der resultierende Farbort ist insbesondere als weißes Licht wahrnehmbar, wobei dieses je nach Anwendungsbereich auch eine gewisse farbige Tönung aufweisen kann, beispielsweise eine rötliche oder gelbliche Tönung.

Mit dem angegebenen Verfahren lässt sich der resultierende Farbort sehr exakt einstellen, da die konvertierenden Eigenschaften der Konversionsschicht auf Grund ihrer geringen Dicke und der Verwendung mindestens eines Leuchtstoffs in Form von Nanopartikeln genau kontrollierbar und einstellbar sind. Der Farbort wird jeweils in Hauptabstrahlrichtung eines Bauelements gemessen. Bauelemente, die nach dem vorhergehend anhand der Figuren 9 bis 11 erläuterten Verfahren hergestellt sind und für die derselbe Farbort in dem CIE-Farbdiagramm vorgesehen ist, weisen für die x- und y-Koordinaten der resultierenden Farborte Werte auf, die mit einer statistischen Sicherheit von mindestens 95 %, beispielsweise 97 %, innerhalb eines Intervalles mit einer Größe von kleiner als oder gleich 0,03 liegen.

Die Leuchtstoffpartikel bzw. Agglomerate aus Leuchtstoffpartikeln sind derart ausgewählt und angeordnet, dass sie elektromagnetische Strahlung aus einem Bereich zwischen einschließlich 360 nm und 500 nm oder 520 nm in eine längerwellige Strahlung derart konvertieren, dass die erforderliche Helligkeit und das notwendige homogene Leuchtbild bei einer präzisen Einstellung des resultierenden Farbortes realisiert werden können. Dies gilt insbesondere für eine Anwendung im allgemeinen Beleuchtungsbereich, bei der Hochleistungs-Lumineszenzdioden mit einer elektrischen Leistung von beispielsweise bis zu 100 mW betrieben werden. Die Leuchtstoffe in Form von Nanopartikeln weisen verbreiterte Absorptionsbanden, eine höhere optische Transparenz sowie deutlich geringere Abklingzeiten nach einer Anregung auf als Leuchtstoffpartikel mit Durchmessern im Bereich von Mikrometern. Dies ermöglicht die Herstellung von Konversionselementen, die insbesondere im Bereich der Allgemeinbeleuchtung hohen Anforderungen entsprechen und die kostengünstig herstellbar sind. Ein weiterer Vorteil von Leuchtstoffen in Form von Nanopartikeln ist, dass sie bei gleichem Volumen eine deutlich größere Oberfläche aufweisen als Leuchtstoffpartikel mit Durchmessern im Mikrometerbereich, wodurch ein verbessertes Abstrahlverhalten möglich ist. Zudem können Leuchtstoffe in Form von Nanopartikeln geringere Schwankungen der Partikeloberflächen als größere Leuchtstoffpartikel aufweisen, d.h. sie können regelmäßigere Oberflächen aufweisen. Dadurch kann ihr Abstrahlverhalten ebenfalls vorteilhaft beeinflusst sein.

Die hier beschriebenen Konvertermaterialien und Konversionsschichten weisen im Vergleich zu herkömmlichen Leuchtstoffen und Leuchtstoffpartikeln Vorteile auf. Oberflächenwechselwirkungen zwischen Leuchtstoffpartikeln können verringert werden, was zu homogeneren Verteilungen des Leuchtstoffs im jeweiligen Matrixmaterial führt. Bei der Verwendung von Leuchtstoffen in Form von Nanopartikeln können optische Löschungen, Transparenzverluste und damit verbundene Helligkeitsverluste, starke Farbortverschiebungen oder unzulässige Farborttoleranzen sowie inhomogene Leuchtbilder signifikant verringert oder vermieden werden. Wirkungsvolle Konversionsschichten mit einer Dicke von maximal 50 µm oder sogar kleiner als 5 µm lassen sich bei der Verwendung von Nanopartikeln im Unterschied zu den herkömmlich verwendeten Leuchtstoffpartikeln technisch mit vertretbarem Aufwand realisieren.

Weiterhin ist es bei der Verwendung von Leuchtstoffen in Form von Nanopartikeln möglich, Leuchtstoffagglomerate mit geringer Ausdehnung gezielt zu erzeugen. Dagegen ist bei herkömmlichen Leuchtstoffen die Bildung von Agglomeraten einerseits unerwünscht, andererseits ist eine Vermeidung von Agglomeraten mit einer Ausdehnung von größer als oder gleich 20 µm in der Regel nur durch zusätzlichen technischen Aufwand zu vermeiden.

Mit Leuchtstoffen in Form von Nanopartikeln können deutlich geringere Abklingzeiten von Sättigungs- und Re-Absorptionseffekten sowie geringere temperaturbedingte Verschiebungen im Leuchtstoffemissionsspektrum erzielt werden als mit herkömmlich verwendeten Leuchtstoffen. Dies ist insbesondere bei einer Verwendung mit Hochleistungs-Lumineszenzdioden im Allgemeinbeleuchtungsbereich von Vorteil. Die Lumineszenzdioden haben beispielsweise eine elektrische Leistung von bis zu 100 mW.

Wenn für den Bereich der Allgemeinbeleuchtung unter Verwendung von Lumineszenzdioden weißes Licht erzeugt werden soll, erfordert dies sehr enge Toleranzen für die x- und y-Koordinaten des CIE-Diagramms, das heißt für den Farbort. Derart enge Toleranzen können bei der Verwendung von Leuchtstoffen in Form von Nanopartikeln gut realisiert werden, während dies bei der Verwendung von herkömmlichen Leuchtstoffen derzeit nur mit hohem technischem Aufwand und zusätzlichen Kosten sowie hohen Ausschussraten möglich ist. Darüberhinaus können mögliche anisotrope optische Anregungs-und Emissionsprozesse, die in herkömmlichen Leuchtstoffen auftreten, minimiert werden. Dadurch kann eine gesteigerte Homogenität im gesamten Raumwinkel, in den die elektromagnetische Strahlung emittiert wird, erzielt werden.

Ein wichtiger Grund für die Schwierigkeiten beim Erzielen enger Farborttoleranzen bei Verwendung herkömmlicher Leuchtstoffpartikel ist eine ungünstige Überlappung herkömmlicher Leuchtstoffabsorptionsspektren einerseits und von Emissionsspektren von Lumineszenzdiodenchips auf der Basis von InGaN oder GaN andererseits. Das Absorptionsspektrum und das Emissionsspektrum überlappen in der Regel nur in einem engen Bereich, sodass bereits leichte Verschiebungen von mindestens einem dieser Spektren große Auswirkungen auf den insgesamt realisierten Farbort haben kann. Insbesondere die üblichen fertigungsbedingten Wellenlängenschwankungen im Emissionsspektrum von Lumineszenzdiodenchips führen zu starken Farbortschwankungen und inhomogenen Leuchtbildern entsprechender Bauelemente mit Lumineszenzdiodenchip und Konvertermaterial.

Bei herkömmlich verwendeten Leuchtstoffpartikeln hängt das Absorptionsspektrum unter anderem signifikant von der Korngröße der Leuchtstoffpartikel ab, die einer relativ großen Streuung unterliegt. Diese Abhängigkeit kann bei Leuchtstoffen in Form von Nanopartikeln geringer ausgeprägt sein. Zudem ist es bei Nanopartikeln möglich, wohldefinierte Korngrößen reproduzierbarer zu erzeugen.

Leuchtstoffe in Form von Nanopartikeln weisen oft eine regelmäßigere Partikelform auf als herkömmliche Leuchtstoffpartikel mit Durchmessern im Bereich von Mikrometern. Aufgrund ihrer sehr geringen Größe weisen die Nanophosphore ein stark vergrößertes Oberflächen-Volumenverhältnis auf, so dass die Lichtabsorption grundsätzlich aufgrund der großen Oberfläche gesteigert und die längerwellige Emission von der Leuchtstoffoberfläche aufgrund der geringeren Wechselwirkungen an der Oberfläche störungsfreier erfolgen kann. Weiterhin ermöglichen die Nanophosphore Konvertermaterialien mit einer höheren Transparenz, die zu geringeren Lichtverlusten im Konverterelement führen.

Leuchtstoffe in Form von Nanopartikeln können zudem eine geringere Temperaturabhängigkeit in der Leuchtstoffemission, breitere Absorptionsbanden mit einer höheren Lichtabsorption (A. E. Absorption Efficiency) und verringerte Abklingzeiten zur Verringerung von Sättigungs- und Selbstabsorptionseffekten aufweisen.

Der CIE-Farbort des Mischlichtes von Licht emittierenden Bauelementen mit Konvertermaterialien kann insbesondere durch Wahl und Kombination der Leuchtstoffe, der Leuchtstoffkonzentration oder Leuchtstoffkonzentrationen im Matrixmaterial und gegebenenfalls der Schichtdicke der Konversionsschicht gezielt gesteuert und präzise eingestellt werden.

Die Erläuterung der Erfindung anhand der oben beschriebenen Bauelemente ist natürlich nicht als Beschränkung der Erfindung auf diese zu betrachten. Als Halbleiterkörper, wie beispielsweise Leuchtdioden-Chips oder Laserdioden-Chips, ist beispielsweise auch eine Polymer-LED oder organische Leuchtdiode zu verstehen, die ein enstprechendes Strahlungsspektrum aussendet.

## Patentansprüche

1. Wellenlängenkonvertierendes Konvertermaterial, das mindestens einen wellenlängenkonvertierenden Leuchtstoff mit Leuchtstoffpartikeln aufweist,
ein Teil des Leuchtstoffes oder der gesamte Leuchtstoff in Form von Nanopartikeln vorliegt und die Nanopartikel einen d₅₀-Wert, gemessen in Q₃ oder Q₀, aufweisen, der größer als oder gleich 1 nm und kleiner als oder gleich 100 nm ist,
**dadurch gekennzeichnet, dass**
das Konvertermaterial als eine Folie vorliegt.

2. Wellenlängenkonvertierendes Konvertermaterial nach Anspruch 1,
**dadurch gekennzeichnet, dass**
die Nanopartikel einen d₅₀-Wert gemessen in Q₃ oder Q₀ aufweisen, der größer als oder gleich 1 nm und kleiner als oder gleich 30 nm ist.

3. Wellenlängenkonvertierendes Konvertermaterial nach einem der vorhergehenden Ansprüche,
**dadurch gekennzeichnet, dass**
die Nanopartikel teilweise oder vollständig zu Agglomeraten verbunden sind, die einen d₅₀-Wert gemessen in Q₃ oder Q₀ aufweisen, der größer als oder gleich 1 nm und kleiner als oder gleich 100 nm ist.

4. Wellenlängenkonvertierendes Konvertermaterial nach einem der vorhergehenden Ansprüche,
**dadurch gekennzeichnet, dass**
das Konvertermaterial mindestens eines der Materialien Epoxidgießharz, Epoxidharzpressmasse, Acrylat, Silikon und Thermoplast aufweist.

5. Wellenlängenkonvertierendes Konvertermaterial nach Anspruch 4,
**dadurch gekennzeichnet, dass**
das Konvertermaterial mindestens ein Hybridmaterial umfasst, das Silikon und mindestens eines der Materialien Epoxidharz und Acrylat aufweist.

6. Wellenlängenkonvertierendes Konvertermaterial nach Anspruch 4,
**dadurch gekennzeichnet, dass**
das Konvertermaterial mindestens einen Thermoplast aus der Gruppe bestehend aus Poly-n-methylmethacrylimid (PMMI), Polycarbonate (PC), Polyamide (PA), Polystyrol (PS), cykloolefinische Polymere (COP) und Copolymere (COC) aufweist.

7. Wellenlängenkonvertierendes Konvertermaterial nach einem der vorhergehenden Ansprüche,
**dadurch gekennzeichnet, dass** das Konvertermaterial mindestens ein anorganisches Matrixmaterial aufweist.

8. Wellenlängenkonvertierendes Konvertermaterial nach einem der vorhergehenden Ansprüche,
**dadurch gekennzeichnet, dass**
der Leuchtstoff zusätzlich Leuchtstoffpartikel mit einem d₅₀-Wert gemessen in Q₃ oder Q₀ von größer als 0,1 µm und kleiner als oder gleich 25 µm aufweist oder das Konvertermaterial einen weiteren Leuchtstoff mit derartigen Leuchtstoffpartikeln aufweist.

9. Wellenlängenkonvertierendes Konvertermaterial nach einem der vorhergehenden Ansprüche,
**dadurch gekennzeichnet, dass**
der Leuchtstoff zusätzlich Leuchtstoffpartikel mit einem d₅₀-Wert gemessen in Q₃ oder Q₀ von größer als oder gleich 5 µm und kleiner als oder gleich 20 µm aufweist oder das Konvertermaterial einen weiteren Leuchtstoff mit derartigen Leuchtstoffpartikeln aufweist.

10. Wellenlängenkonvertierendes Konvertermaterial nach Anspruch 4,
**dadurch gekennzeichnet, dass**
das Konvertermaterial mindestens ein additionsvernetzendes Silikon aufweist.

11. Wellenlängenkonvertierendes Konvertermaterial nach Anspruch 10,
**dadurch gekennzeichnet, dass**
das Silikon thermisch oder photonisch härtend ist.

12. Wellenlängenkonvertierendes Konvertermaterial nach einem der vorhergehenden Ansprüche,
**dadurch gekennzeichnet, dass**
der Leuchtstoff zumindest Leuchtstoffpartikel aus der Gruppe der mit seltenen Erden dotierten Granate, mit seltenen Erden dotierten Thiogallate, mit seltenen Erden dotierten Aluminate oder mit seltenen Erden dotierten Orthosilikate oder Leuchtstoffpartikel mit oxidischen Wirtsgittern mit mindestens einem Aktivator aus der Gruppe gebildet aus den seltenen Erden, Mn, Ag und Cr enthält.

13. Wellenlängenkonvertierendes Konvertermaterial nach einem der vorhergehenden Ansprüche,
**dadurch gekennzeichnet, dass**
die Leuchtstoffpartikel Elemente der Lanthanide, Mangan, Chrom, Silber oder Uranyl als Aktivator-Ionen aufweisen.

14. Wellenlängenkonvertierendes Konvertermaterial nach einem der vorhergehenden Ansprüche,
**dadurch gekennzeichnet, dass**
mindestens zwei verschiedene Leuchtstoffe enthalten sind, die teilweise oder vollständig in Form von Nanopartikeln vorliegen.

15. Wellenlängenkonvertierendes Konvertermaterial nach einem der Ansprüche 1 bis 13,
**dadurch gekennzeichnet, dass**
mindestens zwei verschiedene Leuchtstoffe enthalten sind, von denen nur eines teilweise oder vollständig in Form von Nanopartikeln vorliegt.

16. Wellenlängenkonvertierendes Konvertermaterial nach einem der vorhergehenden Ansprüche,
**dadurch gekennzeichnet, dass**
mindestens ein anorganischer Leuchtstoff in Form von Nanopartikeln und mindestens ein organischer Leuchtstoff enthalten sind.

17. Wellenlängenkonvertierendes Konvertermaterial nach einem der vorhergehenden Ansprüche,
**dadurch gekennzeichnet, dass**
optisch nicht anregbare Streupartikel mit einem d₅₀-Wert gemessen in Q₃ oder Q₀ von größer als 100 nm und kleiner als oder gleich 10 µm enthalten sind.

18. Wellenlängenkonvertierendes Konvertermaterial nach einem der vorhergehenden Ansprüche,
**dadurch gekennzeichnet, dass**
der in Form von Nanopartikeln vorliegende Leuchtstoff gleichartige Partikel mit denselben Bestandteilen eines Wirtsgittermaterials oder mit demselben Wirtsgittermaterial enthält, die denselben Aktivator mit unterschiedlichen Aktivatorkonzentrationen aufweisen.

19. Wellenlängenkonvertierendes Konvertermaterial nach Anspruch 18,
**dadurch gekennzeichnet, dass**
die Aktivatorkonzentration eines erstens Teils der gleichartigen Partikel zwischen einschließlich 0,1 Atom% und einschließlich 3 Atom% beträgt und die Aktivatorkonzentration eines zweiten Teils der gleichartigen Partikel zwischen 3 Atom% und einschließlich 10 Atom% beträgt.

20. Wellenlängenkonvertierendes Konvertermaterial nach einem der vorhergehenden Ansprüche,
**dadurch gekennzeichnet, dass**
mindestens ein Leuchtstoff mit einem Wirtsgitter enthalten ist, in dem mindestens zwei verschiedene Elemente gleichzeitig als Aktivator enthalten sind.

21. Wellenlängenkonvertierendes Konvertermaterial nach einem der vorhergehenden Ansprüche,
**dadurch gekennzeichnet, dass**
das Konvertermaterial mindestens ein Reaktionsharz mit mindestens einer lagerstabilen Härterformulierung als Epoxidgießharzformulierung aufweist.

22. Wellenlängenkonvertierendes Konvertermaterial nach Anspruch 21,
**dadurch gekennzeichnet, dass**
die Härterformulierung einen oder mehrere der Stoffe Carbonsäureanhydride mit sauren Estern, d.h. Carbonsäureanhydridhalbester, Flexibilisatoren, organische Phosphorverbindungen, Initiatoren und Beschleuniger aufweist.

23. Wellenlängenkonvertierendes Konvertermaterial nach einem der Ansprüche 21 und 22,
**dadurch gekennzeichnet, dass**
die Härterformulierung mindestens eine Komplexverbindung des farblosen Zn²⁺-Ions als Beschleuniger aufweist.

24. Wellenlängenkonvertierendes Konvertermaterial nach Anspruch 23,
**dadurch gekennzeichnet, dass**
die Komplexverbindung des farblosen Zn²⁺-Ions organische ionische Liganden aufweist.

25. Wellenlängenkonvertierendes Konvertermaterial nach Anspruch 23,
**dadurch gekennzeichnet, dass**
die Härterformulierung Zinkoktoat als Beschleuniger aufweist.

26. Wellenlängenkonvertierendes Konvertermaterial nach Anspruch 23 oder 25,
**dadurch gekennzeichnet, dass**
die Komplexverbindung einen Zn²⁺-Gehalt von größer als 10 Gewichts-% aufweist.

27. Wellenlängenkonvertierendes Konvertermaterial nach Anspruch 23 oder 25,
**dadurch gekennzeichnet, dass**
die Komplexverbindung einen Zn²⁺-Gehalt von größer als oder gleich 21 Gewichts-% aufweist.

28. Wellenlängenkonvertierendes Konvertermaterial nach einem der vorhergehenden Ansprüche,
bei der ein Anteil des Leuchtstoffs in dem Konvertermaterial zwischen einschließlich 60 Gew-% und einschließlich 80 Gew-% liegt.

29. Lichtabstrahlendes optisches Bauelement,
**dadurch gekennzeichnet, dass**
es eine Strahlungsquelle und ein wellenlängenkonvertierendes Konvertermaterial gemäß einem der Ansprüche 1 bis 28 aufweist, mittels dem eine von der Strahlungsquelle emittierte elektromagnetische Strahlung teilweise oder vollständig in Strahlung mit veränderten Wellenlängen konvertiert wird.

30. Lichtabstrahlendes optisches Bauelement gemäß Anspruch 29,
**dadurch gekennzeichnet, dass**
es für Allgemeinbeleuchtung vorgesehen ist.

31. Lichtabstrahlendes optisches Bauelement nach einem der Ansprüche 29 und 30,
**dadurch gekennzeichnet, dass**
die Lichtquelle eine organische Lumineszenzdiode aufweist, die mit dem Konvertermaterial versehen ist oder das Konvertermaterial aufweist.

32. Lichtabstrahlendes optisches Bauelement nach einem der Ansprüche 29 bis 31,
**dadurch gekennzeichnet, dass**
die Strahlungsquelle in dem Bauelement im Pulsbetrieb betrieben wird und/oder das Bauelement für optische Schaltprozesse vorgesehen ist.

33. Verfahren zum Herstellen eines lichtabstrahlenden optischen Bauelements, mit den Schritten:
- Bereitstellen einer elektromagnetischen Strahlungsquelle, und
- Aufbringen eines wellenlängenkonvertierenden Konvertermaterials auf die Strahlungsquelle, wobei das wellenlängenkonvertierende Konvertermaterial mindestens einen wellenlängenkonvertierenden Leuchtstoff aufweist, der Leuchtstoff zumindest teilweise in Form von Nanopartikeln vorliegt und das Konvertermaterial teilweise oder vollständig die Form einer Schicht mit einer Dicke von kleiner als oder gleich 50 µm aufweist,
**dadurch gekennzeichnet, dass**
das Konvertermaterial vor dem Aufbringen auf die Strahlungsquelle in Form einer Folie bereitgestellt wird.

## Claims

1. A wavelength converting converter material comprising at least one wavelength converting phosphor having phosphor particles,
part of the phosphor or the whole phosphor is present in the form of nanoparticles and the nanoparticles have a d₅₀-value, measured in Q₃ or Q₀, greater than or equal to 1 nm and less than or equal to 100 nm,
**characterised in that**
the converter material is present as a film.

2. The wavelength converting converter material according to claim 1,
**characterised in that**
the nanoparticles have a d₅₀-value measured in Q₃ or Q₀ which is greater than or equal to 1 nm and less than or equal to 30 nm.

3. The wavelength converting converter material according to one of the previous claims,
**characterised in that**
the nanoparticles are partially or completely bonded to form agglomerates having a d₅₀-value measured in Q₃ or Q₀ which is greater than or equal to 1 nm and less than or equal to 100 nm.

4. The wavelength converting converter material according to one of the previous claims,
**characterised in that**
the converter material comprises at least one of the materials: epoxy casting resin, epoxy resin molding compound, acrylate, silicone and thermoplastic.

5. The wavelength converting converter material according to claim 4,
**characterised in that**
the converter material comprises at least one hybrid material comprising silicone and at least one of the materials: epoxy resin and acrylate.

6. The wavelength converting converter material according to claim 4,
**characterised in that**
the converter material comprises at least one thermoplastic from the group consisting of: poly-n-methylmethacrylimide (PMMI), polycarbonates (PC), polyamides (PA), polystyrene (PS), cycloolefinic polymers (COP) and copolymers (COC).

7. The wavelength converting converter material according to one of the previous claims,
**characterised in that**
the converter material comprises at least one inorganic matrix material.

8. The wavelength converting converter material according to one of the previous claims,
**characterised in that**
the phosphor additionally comprises phosphor particles having a d₅₀-value measured in Q₃ or Q₀ of greater than 0.1 µm and less than or equal to 25 µm, or the converter material comprises a further phosphor having such phosphor particles.

9. The wavelength converting converter material according to one of the previous claims,
**characterised in that**
the phosphor additionally comprises phosphor particles having a d₅₀-value measured in Q₃ or Q₀ of greater than or equal to 5 µm and less than or equal to 20 µm, or the converter material comprises a further phosphor having such phosphor particles.

10. The wavelength converting converter material as claimed in claim 4,
**characterised in that**
the converter material comprises at least one addition-crosslinking silicone.

11. The wavelength converting converter material according to claim 10,
**characterised in that**
the silicone is thermally or photonically curing.

12. The wavelength converting converter material according to one of the previous claims,
**characterised in that**
the phosphor contains at least phosphor particles from the group of rare earth doped garnets, rare earth doped thiogallates, rare earth doped aluminates or rare earth doped orthosilicates or phosphor particles having oxidic host lattices with at least one activator from the group formed from the rare earths, Mn, Ag and Cr.

13. The wavelength converting converter material according to one of the previous claims,
**characterised in that**
the phosphor particles contain elements of lanthanides, manganese, chromium, silver or uranyl as activator ions.

14. The wavelength converting converter material according to one of the previous claims,
**characterised in that**
it comprises at least two different phosphors which are present partially or completely in the form of nanoparticles.

15. The wavelength converting converter material according to any of claims 1 to 13,
**characterised in that**
it comprises at least two different phosphors, only one of which is in the form of nanoparticles.

16. The wavelength converting converter material according to one of the previous claims,
**characterised in that**
contain at least one inorganic phosphor in the form of nanoparticles and at least one organic phosphor.

17. The wavelength converting converter material according to one of the previous claims,
**characterised in that**
it contains non-optically excitable scattering particles having a d₅₀ value measured in Q3 or Q0 which is greater than 100 nm and less than or equal to 10 µm.

18. The wavelength converting converter material according to one of the previous claims,
**characterised in that**
the phosphor present in the form of nanoparticles contains particles of the same kind with the same constituents of a host lattice material or with the same host lattice material, which have the same activator with different activator concentrations.

19. The wavelength converting converter material according to claim 18,
**characterised in that**
the activator concentration of a first part of the particles of the same kind is between 0.1 atom % and 3 atom %, inclusive, and the activator concentration of a second part of the particles of the same kind is between 3 atom % and 10 atom %, inclusive.

20. The wavelength converting converter material according to one of the previous claims,
**characterised in that**
it contains at least one phosphor with a host lattice in which at least two different elements are simultaneously contained as activator.

21. The wavelength converting converter material according to one of the previous claims,
**characterised in that**
the converter material comprises at least one reaction resin that contains, as an epoxy casting resin formulation, at least one storage-stable curing agent formulation.

22. The wavelength converting converter material according to claim 21,
**characterised in that**
the curing agent formulation comprises one or more of the substances carboxylic acid anhydrides with acid esters, i.e. carboxylic acid anhydride half-esters, flexibilizers, organic phosphorus compounds, initiators and accelerators.

23. The wavelength converting converter material according to claims 21 and 22,
**characterised in that**
the curing agent formulation comprises at least one complex compound of the colorless Zn²⁺-ion as accelerator.

24. The wavelength converting converter material according to claim 23,
**characterised in that**
the complex compound of the colorless Zn²⁺-ion has organic ionic ligands.

25. The wavelength converting converter material according to claim 23,
**characterised in that**
the curing agent formulation comprises zinc coctoate as an accelerator.

26. The wavelength converting converter material according to claim 23 or 25,
**characterised in that**
the complex compound has a Zn²⁺ content of greater than 10 % by weight.

27. The wavelength converting converter material according to claim 23 or 25,
**characterised in that**
the complex compound has a Zn²⁺ content greater than or equal to 21 % by weight.

28. The wavelength converting converter material according to one of the previous claims,
in which a proportion of the phosphor in the converter material is between 60 % and 80 % by weight, inclusive.

29. A light-emitting optical component,
**characterised in that**
it comprises a radiation source and a wavelength converting converter material according to any one of claims 1 to 28, by means of which electromagnetic radiation emitted by the radiation source is partially or completely converted into radiation having modified wavelengths.

30. The light-emitting optical component according to claim 29,
**characterised in that**
it is configured for general lighting.

31. The light-emitting optical component according to one of claims 29 and 30,
**characterised in that**
the light source comprises an organic luminescent diode provided with the converter material or comprising the converter material.

32. The light-emitting optical component according to one of claims 29 to 31,
**characterised in that**
the radiation source in the component is operated in pulsed mode and/or the component is configured for optical switching processes.

33. A method for producing a light emitting optical device, comprising the steps:
- providing an electromagnetic radiation source, and
- applying a wavelength converting converter material to the radiation source, wherein the wavelength converting converter material comprises at least one wavelength converting phosphor, the phosphor is at least partially present in the form of nanoparticles, and the converter material is partially or completely in the form of a layer having a thickness of less than or equal to 50 µm,
**characterised in that**
the converter material is provided in the form of a film before being applied onto the radiation source.

## Revendications

1. Matériau convertisseur de longueur d'onde qui présente au moins une substance luminescente à particules de substance luminescente, convertissant les longueurs d'onde,
une partie de la substance luminescente ou l'ensemble de la substance luminescente est disponible sous forme de nanoparticules et lesdites nanoparticules présentent une valeur d₅₀, mesurée en Q₃ ou Q₀, qui est supérieure ou égale à 1 nm et inférieure ou égale à 100 nm,
**caractérisé en ce que**
le matériau convertisseur est disponible en tant que film.

2. Matériau convertisseur de longueur d'onde selon la revendication 1,
**caractérisé en ce que**
les nanoparticules présentent une valeur d₅₀, mesurée en Q₃ ou Q₀, qui est supérieure ou égale à 1 nm et inférieure ou égale à 30 nm.

3. Matériau convertisseur de longueur d'onde selon l'une quelconque des revendications précédentes,
**caractérisé en ce que**
les nanoparticules sont reliées en partie ou intégralement en agglomérats qui présentent une valeur d₅₀, mesurée en Q₃ ou Q₀, qui est supérieure ou égale à 1 nm et inférieure ou égale à 100 nm.

4. Matériau convertisseur de longueur d'onde selon l'une quelconque des revendications précédentes,
**caractérisé en ce que**
le matériau convertisseur présente au moins un des matériaux choisi parmi la résine époxyde à mouler, la pâte de moulage en résine époxyde, l'acrylate, le silicone et les thermoplastiques.

5. Matériau convertisseur de longueur d'onde selon la revendication 4,
**caractérisé en ce que**
le matériau convertisseur comprend au moins un matériau hybride qui présente du silicone et au moins un des matériaux choisi parmi la résine époxyde et l'acrylate.

6. Matériau convertisseur de longueur d'onde selon la revendication 4,
**caractérisé en ce que**
le matériau convertisseur présente au moins une matière thermoplastique choisie parmi le groupe composé de poly-n-méthylméthacrylamides (PPMI), polycarbonates (PC), polyamides (PA), polystyrènes (PS), polymères cyclooléfiniques (COP) et copolymères (COC).

7. Matériau convertisseur de longueur d'onde selon l'une quelconque des revendications précédentes,
**caractérisé en ce que**
le matériau convertisseur présente au moins un matériau de matrice anorganique.

8. Matériau convertisseur de longueur d'onde selon l'une quelconque des revendications précédentes,
**caractérisé en ce que**
la substance luminescente présente en supplément des particules de substance luminescente d'une valeur d₅₀ mesurée en Q₃ ou Q₀ et supérieure à 0,1 µm et inférieure ou égale à 25 µm, ou le matériau convertisseur présente une autre substance luminescente dotée de telles particules de substance luminescente.

9. Matériau convertisseur de longueur d'onde selon l'une quelconque des revendications précédentes,
**caractérisé en ce que**
la substance luminescente présente en supplément des particules de substance luminescente d'une valeur d₅₀ mesurée en Q₃ ou Q₀ et supérieure à 5 µm et inférieure ou égale à 20 µm, ou le matériau convertisseur présente une autre substance luminescente dotée de telles particules de substance luminescente.

10. Matériau convertisseur de longueur d'onde selon la revendication 4,
**caractérisé en ce que**
le matériau convertisseur présente au moins un silicone réticulant par addition.

11. Matériau convertisseur de longueur d'onde selon la revendication 10,
**caractérisé en ce que**
le silicone durcit par voie thermique ou par voie photonique.

12. Matériau convertisseur de longueur d'onde selon l'une quelconque des revendications précédentes,
**caractérisé en ce que**
la substance luminescente comprend au moins des particules de substance luminescente choisies parmi le groupe des grenades dopées aux terres rares, des thiogallates dopés aux terres rares, des aluminates dopés aux terres rares ou des orthosilicates dopés aux terres rares ou des particules de substance luminescente dotées de grilles hôtes en oxyde avec au moins un activateur choisi parmi le groupe composé des terres rares, Mn, Ag et Cr.

13. Matériau convertisseur de longueur d'onde selon l'une quelconque des revendications précédentes,
**caractérisé en ce que**
les particules de substance luminescente présentent des éléments des lanthanides, manganèse, chrome, argent ou uranyle en tant qu'ions activateurs.

14. Matériau convertisseur de longueur d'onde selon l'une quelconque des revendications précédentes,
**caractérisé en ce que**
sont comprises au moins deux substances luminescentes distinctes, lesquelles sont partiellement ou intégralement présentes sous forme de nanoparticules.

15. Matériau convertisseur de longueur d'onde selon l'une quelconque des revendications 1 à 13,
**caractérisé en ce que**
sont comprises au moins deux substances luminescentes distinctes, dont une seulement est, partiellement ou intégralement, présente sous forme de nanoparticules.

16. Matériau convertisseur de longueur d'onde selon l'une quelconque des revendications précédentes,
**caractérisé en ce que**
sont comprises au moins une substance luminescente sous forme de nanoparticules et au moins une substance luminescente organique.

17. Matériau convertisseur de longueur d'onde selon l'une quelconque des revendications précédentes,
**caractérisé en ce que**
sont comprises des particules vagabondes non excitables optiquement, d'une valeur d₅₀ mesurée en Q₃ ou Q₀ supérieure à 100 nm et inférieure ou égale à 10 µm.

18. Matériau convertisseur de longueur d'onde selon l'une quelconque des revendications précédentes,
**caractérisé en ce que**
la substance luminescente présente sous forme de nanoparticules comprend des particules similaires aux mêmes composants qu'un matériau de grille hôte ou avec le même matériau de grille hôte, qui présentent les mêmes activateurs à des concentrations d'activateur différentes.

19. Matériau convertisseur de longueur d'onde selon la revendication 18,
**caractérisé en ce que**
la concentration en activateur d'une première partie des particules similaires est comprise entre 0,1 de pourcentage atomique inclus et 3 de pourcentage atomique inclus, et la concentration en activateur d'une deuxième partie des particules similaires est entre 3 de pourcentage atomique et 10 de pourcentage atomique inclus.

20. Matériau convertisseur de longueur d'onde selon l'une quelconque des revendications précédentes,
**caractérisé en ce qu'**
est comprise au moins une substance luminescente dotée d'une grille hôte dans laquelle sont compris au moins deux éléments différents simultanément en tant qu'activateurs.

21. Matériau convertisseur de longueur d'onde selon l'une quelconque des revendications précédentes,
**caractérisé en ce que**
le matériau convertisseur présente au moins une résine de réaction avec au moins une formule de durcisseur stable au repos en tant que formule de résine époxyde coulée.

22. Matériau convertisseur de longueur d'onde selon la revendication 21,
**caractérisé en ce que**
la formule de durcisseur présente une ou plusieurs des substances anhydrides carboxyliques à plusieurs esters, c'est-à-dire des hémi-esters d'anhydrides carboxyliques, flexibilisateurs, composés phosphoriques organiques, initiateurs et accélérateurs.

23. Matériau convertisseur de longueur d'onde selon l'une quelconque des revendications 21 et 22,
**caractérisé en ce que**
la formule de durcisseur présente au moins un composé complexe du ion incolore Zn²⁺ en tant qu'accélérateur.

24. Matériau convertisseur de longueur d'onde selon la revendication 23,
**caractérisé en ce que**
le composé complexe du ion incolore Zn²⁺ présente des ligands ioniques organiques.

25. Matériau convertisseur de longueur d'onde selon la revendication 23,
**caractérisé en ce que**
la formule de durcisseur présente de l'octoate de zinc en tant qu'accélérateur.

26. Matériau convertisseur de longueur d'onde selon la revendication 23 ou 25,
**caractérisé en ce que**
le composé complexe présente une teneur en Zn²⁺ supérieure à 10 % de poids.

27. Matériau convertisseur de longueur d'onde selon la revendication 23 ou 25,
**caractérisé en ce que**
le composé complexe présente une teneur en Zn²⁺ supérieure ou égale à 21 % de poids.

28. Matériau convertisseur de longueur d'onde selon l'une quelconque des revendications précédentes,
dans lequel une part de substance luminescente dans le matériau convertisseur de longueur d'onde est comprise entre 60 % de poids, inclus, et 80 % de poids, inclus.

29. Composant optique émetteur de lumière,
**caractérisé en ce qu'**
il présente une source d'émission et un matériau convertisseur de longueur d'onde selon l'une quelconque des revendications 1 à 28, au moyen duquel un rayonnement électromagnétique émis par la source de rayonnement est converti partiellement ou intégralement en rayonnement à longueurs d'onde modifiées.

30. Composant optique émetteur de lumière selon la revendication 29,
**caractérisé en ce qu'**
il est prévu pour un éclairage général.

31. Matériau convertisseur de longueur d'onde selon l'une quelconque des revendications 29 et 30,
**caractérisé en ce que**
la source de lumière présente une diode électroluminescente organique qui est pourvue d'un matériau convertisseur ou qui présente le matériau convertisseur.

32. Composant optique émetteur de lumière selon l'une quelconque des revendications 29 à 31,
**caractérisé en ce que**
la source de rayonnement dans le composant fonctionne par impulsion et/ou le composant est prévu pour des processus de commutation optiques.

33. Procédé de fabrication d'un composant optique émetteur de lumière comprenant les étapes :
- fourniture d'une source de rayonnement électromagnétique, et
- application d'un matériau convertisseur de longueur d'onde sur la source de rayonnement, ledit matériau convertisseur de longueur d'onde présentant au moins une substance luminescente convertisseuse de longueur d'onde, ladite substance luminescente étant présente au moins partiellement sous forme de nanoparticules et le matériau convertisseur présentant partiellement ou intégralement la forme d'une couche d'une épaisseur inférieure ou égale à 50 µm, **caractérisé en ce que**
le matériau convertisseur est fourni sous forme d'un film avant d'être appliqué sur la source de rayonnement.
